# EUROPEAN PATENT SPECIFICATION

(11) **EP 4 099 008 B1**
(45) Date of publication and mention of the grant of the patent: **22.07.2026**
(21) Application number: 22187612.1
(22) Date of filing: 03.10.2019
(51) Int. Cl.: G01N 29/04, G01N 29/28, G01N 29/265, G01N 29/24, G01N 29/22, G01N 29/06, H10P 72/78, H10P 72/00

(54) **WAFER CHUCK FOR ULTRASONIC INSPECTION**
SPANNVORRICHTUNG EINER HALBLEITERSCHEIBE ZUR ULTRASCHALLINSPEKTION
SUPPORT D'UNE PLAQUETTE SEMI-CONDUCTRICE POUR UNE INSPECTION PAR ULTRASONS

(30) Priority: 05.10.2018 US 201862741973 P
(43) Date of publication of application: 07.12.2022
(62) Divisional of application: 19868400.3
(73) Proprietor: Sonix, Inc., Springfield, VA 22152 (US)
(72) Inventor: KWON, Young-Shin, Springfield, VA 22152 (US); MCKEON, James Christopher Patrick, Springfield, VA 22152 (US); KEETON, Paul Ivan John, Springfield, VA 22152 (US); WRIGHT, Michael Lemley, Springfield, VA 22152 (US)
(74) Representative: HGF

(56) References cited:
- EP-A1- 3 382 749
- TW-U- M 463 906
- US-A- 5 983 483

## Description

### BACKGROUND

Scanning Acoustic Microscopes are used to nondestructively inspect bonded wafer pairs, wafer pairs, strips, singulated packages and various microelectronic sample types, in the semiconductor industry for defects in the interior of the sample typically at internal interfaces. These defects may be air type defects. Ultrasonic inspection at frequencies greater than approximately 500 kHz requires a couplant for the ultrasound to propagate from the ultrasonic transducer to the sample and back again. Water is suitable couplant since it has desirable attenuative properties and is readily available in semiconductor facilities either as De-ionized (DI) water or as Reverse Osmosis (RO) water or both. The wafer or sample under inspection can be held in place by a chuck.

With water bath systems and "bubbler" systems a large quantity of water is present on the surface and edges of the sample during and after the inspection allowing for water to flow or wick in between the wafers or into any channels or cavities that are present.

Therefore, since water is typically used as the couplant, there is a need to limit water contact during inspection so that water does not enter the interior of the wafer and to speed up drying time. This also applies to any fluid or liquid, or couplant that is used, since excess couplant may have similar deleterious effects on the wafer under inspection.

EP 3 382 749 A1 discloses a wafer chuck including a support structure having a first side structurally configured to support a wafer, and a vacuum zone formed on the first side of the support structure.

TW M 463 906 U discloses a wafer partitioning structure for use in partitioning a wafer.

US 5 983 483 A discloses a workpiece fixing method capable of machining a workpiece with high accuracy by firmly fixing the workpiece with no necessity of using a special freezing chuck device.

### SUMMARY

Embodiments of the invention are set out in the appended claims. The description and drawings may also present additional non-claimed embodiments, exemplary embodiments, examples, aspects and implementations for the better understanding of the claimed embodiments defined in the appended claims.

### BRIEF DESCRIPTION OF THE DRAWINGS

**FIGs. 1A-1C** show an example of a coupler according to the disclosure.
**FIGs. 2A-2C** show another example of a coupler according to the disclosure.
**FIGs. 3A -3C** show an example of the wafer support and suction inlets according to an example of the disclosure.
**FIG. 4** shows an embodiment of a two-part chuck according to the disclosure.
**FIG. 5** shows a substantially cross section view showing a cavity for the suction.
**FIGs. 6A** and **6B** show an example that includes a plurality of vacuum generators.
**FIGs. 7A** and **7B** show an example of a pass to remove excess fluid.
**FIGs. 8A-8F** show an example of a chuck having a lift off portion.
**FIG. 9** shows a flowchart of one example using an example of the coupler with an example of the chuck.
**FIG. 10** shows a flowchart to implement an example of the disclosure.
**FIG. 11** shows a flowchart to suction fluid from an edge of a bonded wafer pair according to an example described herein.
**FIG. 12** shows a representation of raster scanning and movement.
**FIG. 13** shows a flowchart to control positioning of a coupler according to an example described herein.
**FIG. 14** shows a flowchart to remove couplant from a surface of an article according to an example described herein.
**FIG. 15** shows a flowchart to remove couplant from a surface of an article according to another example described herein.

### DETAILED DESCRIPTION

The various methods, systems, apparatus, and devices described herein generally provide for minimization of degradation of a bonded wafer pair, wafer pairs, bonded semi-conductor wafer, strips, singulated packages and various microelectronic sample types, which are referred to herein as bonded wafers, bonded wafer pairs, wafer or article or the like, due to water or other couplant contact during ultrasonic inspection.

This ultrasonic inspection may be performed using ultrasonic sensor(s) to inspect the surface and/or subsurface layer or layers of an article, or sample, as described herein for imperfections, defects or other undesired characteristics. The ultrasonic sensor utilizes a fluid, or couplant, which if absorbed or wicked into the article under inspection, could adversely impact the performance of the article. Using the inspection techniques described herein, a liquid, or couplant is deposited on an upper surface of the bonded wafer pair, or sample, or other article under inspection.

The liquid, while beneficial for providing a medium for the ultrasonic sensing device, is deleterious if absorbed by or exposed to any portion or surface or edge of the bonded wafer pair. The absorption or exposure may occur by couplant that is deposited on an upper surface of the bonded wafer pair during the ultrasonic inspection process flowing over an edge of the bonded wafer pair and being absorbed or wicked into one or more of the layers of the bonded wafer pair from a circumferential edge and/or flowing underneath the bonded wafer pair and being absorbed by a lower or under surface of the bonded wafer pair or entering the bonded wafer pairs through holes in the lower or under surface of the bonded wafer pair. Additionally, excess fluid on an upper surface of the bonded wafer pair is not desired.

The present disclosure relates to a specialized coupler and a specialized wafer chuck. The specialized coupler and specialized wafer chuck can be used separately or with each other.

The coupler may be used with any suitable surface of an article, such as a bonded wafer pair (hereinafter, wafer), to scan and/or inspect a surface for defects, imperfections, or other characteristics. The chuck may be used to support a wafer or other article or object in a desired fashion that may include wicking fluid or water from a surface. As described herein the coupler and the chuck may be used together to scan and/or inspect a wafer that is secured by the chuck.

Excess fluid, or couplant, may be removed from an upper surface of the wafer by one or more suction vacuums disposed on the coupler. Excess fluid or couplant that flows over the upper surface of the wafer may be removed from a circumferential edge of the wafer by vacuums disposed in the chuck.

One example of the present disclosure is directed to a coupler that includes a sensing device, which may be a transducer, or any suitable device having a piezoelectric element, or similar device, disposed on a first portion of the coupler. The sensing device is configured to perform sensing of a plurality of areas of inspection of a wafer. One or more couplant inlet couplings are disposed on a second portion of the coupler, the couplant inlet couplings are configured to provide a couplant to a portion of the wafer that is being inspected by the sensing device. A plurality of vacuum inlet couplings is disposed on a third portion of the coupler. At least one of the vacuum inlet couplings is configured to provide suction through a recessed portion of a lower surface of the coupler to remove couplant that is outside the portion of the wafer that is being inspected, which is the area that is currently being sensed by the sensing device.

Another example of the disclosure is directed to an inspection system that includes two sensing devices, each sensing device being disposed in an associated coupler. A first sensing device, which may be for example, a transducer, disposed on a first portion of a first coupler, the first sensing device configured to perform sensing of areas of inspection of a wafer associated with the first sensing device. One or more couplant inlet couplings is disposed on a second portion of the first coupler, the couplant inlet couplings configured to provide a volume of couplant to a portion of the wafer that is being inspected by the first sensing device. One or more vacuum inlet couplings is disposed on a third portion of the first coupler, at least one of the vacuum inlet couplings configured to provide suction through a recessed portion of a lower surface of the first coupler to remove couplant that is outside the portion of the wafer that is being inspected by the first sensing device.

A second sensing device (transducer) is disposed on a first portion of a second coupler, the second sensing device configured to perform sensing of areas of inspection of a wafer associated with the second sensing device. A second one or more couplant inlet couplings is disposed on a second portion of the second coupler, the second couplant inlet couplings configured to provide a couplant to a portion of the wafer that is being inspected by the second sensing device. A second one or more vacuum inlet couplings is disposed on a third portion of the second coupler, at least one of the second vacuum inlet couplings configured to provide suction through a recessed portion of a lower surface of the second coupler to remove couplant that is outside the portion of the wafer that is being inspected by the second sensing device.

Yet another example of the present disclosure is directed to an apparatus comprising a first section configured to support an article, for example, a wafer, using one or more first vacuum inlets applied to the surface of the article or wafer, with or without contact with the article. A second section is configured to create an annular ring around a circumference of the article (wafer) and uses one or more associated annular vacuum inlets, to collect couplant from an edge portion of the article. Typically, a suction force of the one or more associated vacuum inlets to suction couplant from an edge of the article (wafer, bonded wafer pair) exceeds a wicking force of the couplant on the article. The first section (flat) may include multiple regions, each having associated vacuum inlets applied to the surface of the article or wafer.

Yet still another example of the disclosure is directed to a method for securing a wafer by positioning an article on a first surface of a chuck and suctioning at least a first portion of the article on the first surface of the chuck, utilizing one or more vacuum inlets applied to the surface of the article. Next, at least a second portion of the article is suctioned on an annular ring of the chuck, utilizing one or more annular vacuum inlets disposed on the chuck.

Additionally, the multiple vacuum inlets applied to the surface and the annular vacuum inlets can be operated independently from one another to provide selective suction control to one or more associated vacuum inlets.

Typically, before being ultrasonically inspected, a bonded wafer pair is placed onto some form of wafer chuck to secure it during scanning at speeds which can reach 1.5m/s (1500 mm/second). These chucks can be made of materials such as ceramic, stainless steel, or anodized aluminum for example, and often incorporate a form of surface vacuum to hold the wafer in place. Bonded wafer pairs typically come in five to six standard sizes, for example, 2", 4", 5", 6", 8", and 12", with 6", 8" and 12" being the most common. While these are standard sizes, any suitable size is within the examples described herein. Therefore, the wafer chucks may have different surface vacuum regions for the different sized wafers. For example, one chuck might support 4" to 8" wafer sizes, while a different chuck might support 8" and 12" wafer sizes. In addition, the wafer chucks may be modified to secure warped wafers. Next, a fluid or couplant, such as water, de-ionized water, reverse osmosis water, or other suitable couplant is introduced between the sensing device, which may be an ultrasonic transducer, and the wafer sample. This can be achieved either by immersing the wafer and chuck into a water bath, using a "bubbler" to create a waterfall of water from the transducer location down to the sample, or using a water coupler to create a pressurized film of water between the transducer face and the sample surface.

The sample is inspected by performing a raster scan over the surface of the wafer and sending out an ultrasonic pulse at specific locations to generate reflections from the sample at each (x, y) position. These reflected signals are evaluated to produce images of each interface that can be analyzed for defects in the overall wafer area or in specific semiconductor device areas.

With bonded device wafers, such as Back Side Illuminated (BSI), CMOS, (complementary metal oxide semiconductor) and MEMS (micro-electro-mechanical systems) wafers, there may be openings to the interior of the bonded wafer pair that could allow water or couplant to ingress. This water ingression could lead to the changing of the material properties internal to the bonded wafer pair or contamination of cavities in the bonded wafer pair. In some cases, there are holes in the bottom of the bottom wafer that can be very difficult to dry if water ingresses up the holes and into the interior device cavities.

In other cases, a sponge-like material may be present close to the edge of the wafer and water could wick in between the two wafers and be absorbed by that material changing its ultrasonic properties. This can result in brightness changes in the resulting images that could lead to false or missed failure results. In still other cases, there may be channels open to the edges of the wafer pair, which water could wick into exposing devices or device seals to water.

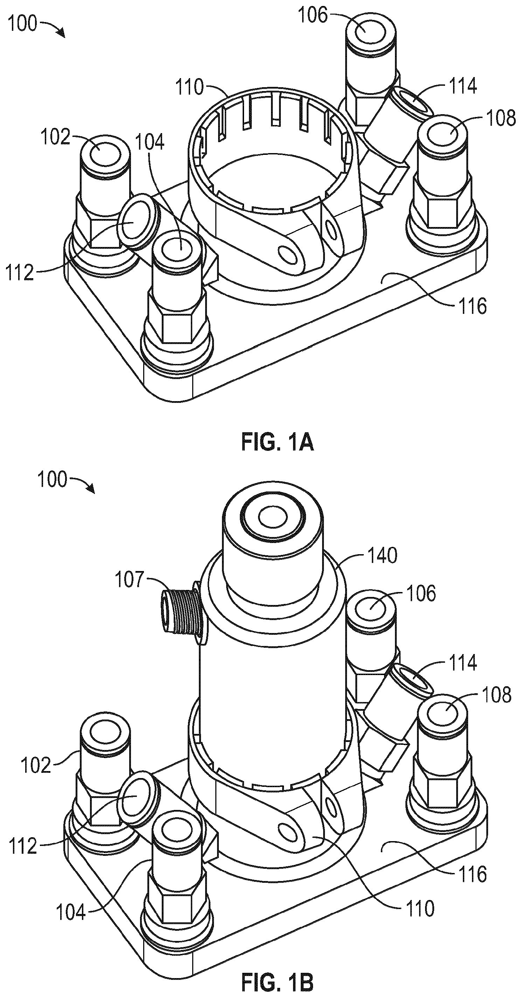

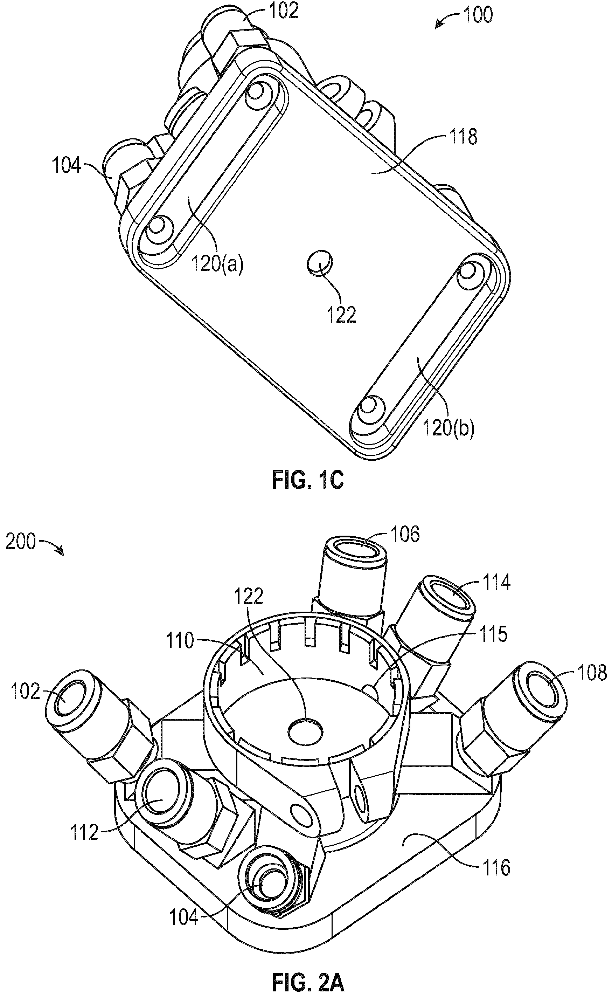

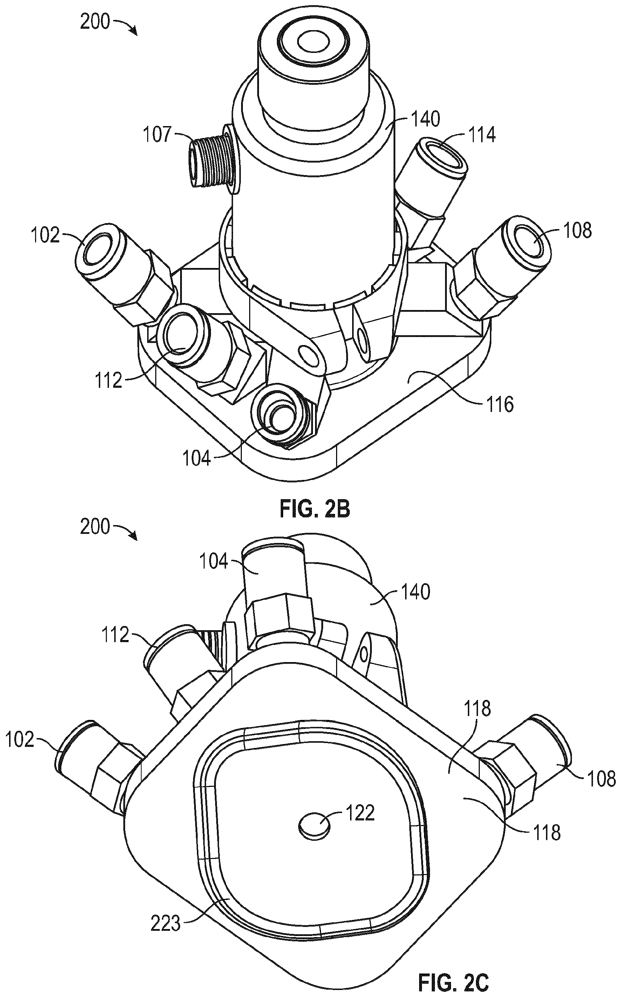

As shown in **FIGs. 1A-1C** and **FIGs. 2A-2C**, the coupler, which may be used with a suitable fluid or a liquid, such as water, or other suitable couplant, has two fluid inlets, four vacuum inlets, and recessed areas for suction on the bottom, or under surface, of the coupler. The fluid may be for example water, which may be at any temperature. The water may be between approximately 15 degrees Celsius and 25 degrees Celsius. The water may also be heated water having a temperature between approximately 30 degrees Celsius and 45 degrees Celsius. The fluid may also be deionized water, reverse osmosis water, or other suitable fluid. Two configurations of the lower surface of the coupler are shown in **FIGs. 1C** and **2C****.**

As shown in **FIGs. 1A** and **1B**, coupler 100 includes four vacuum inlets 102, 104, 106 and 108. Two fluid or couplant inlet ports 112 and 114 are also shown. Sensing device support 110 is used to provide a support for a sensing device, such as a transducer, or suitable scanning device, 140 with coupling 107 on sensing device 140. The coupler 100 has an upper surface 116. When the process begins, the coupler is initially at a first height that is above the surface. It is lowered to a distance above the surface that is suitable for scanning/inspection (operational distance).

The scanning/inspection distance may be between approximately 0.05mm and 50 mm above the surface of the wafer (Z-axis dimension), and may also be between approximately 0.1mm and 30mm above the surface of the wafer (Z-axis dimension). This distance may also be between 0.7 mm and 1 mm. This scanning distance permits the couplant deposition and ultrasonic scanning to occur efficiently. The coupler performing the scanning/inspection operation will typically maintain that distance during the process. It can be elevated upon completion of the desired surface scanning/inspection. This acquired data from the sensing device can be used to generate a summary or report or provided in virtually any desired format, such as a chart, graph etc. This may be generated by a computer processor, memory and peripheral devices. The data may be output as a profile of the bonded wafer pair, or article, indicating a quality or other parameter.

**FIG. 1C** shows a lower surface 118 of coupler 100. The lower or under surface 118 of coupler 100 has recessed portions 120(a) and (b), which are shown as substantially oval shaped. The recessed portions 120(a) and (b) may be used as a channel to provide a suction path so that couplant, or fluid can be removed, or suctioned, from an area under the coupler 100. The sensing device, or transducer, 140 is able to sense a surface of an article, such as a bonded wafer. The sensed data may be accumulated and/or stored and/or transmitted.

**FIG. 1C** shows the bottom view of the two-slot coupler 100 showing the hole 122 and the slots, or vacuum areas 120(a) and 120(b).

The hole, or opening, or port, or orifice, 122 provides a path for the couplant to flow from the couplant inlet to the surface being examined and the hole 122 also provides an opening for at least a portion of the sensing device to perform ultrasonic scanning of a surface and subsurface of an article, utilizing the couplant as the medium. Thus, the hole 122 provides a path for the couplant, such as water, to flow out and create a pressurized film and a port for the sensor device to perform ultrasonic scanning.

As stated herein, the scanning may utilize a sensing device, or scanning device suitable to examine and/or sense imperfections, defects, contours and other properties on a surface and/or subsurface (*i.e.,* a portion of the article below the surface and not visible to the naked eye) of an article, such as a bonded wafer pair, wafer, etc. The sensing/scanning device may include a transducer, or any ultrasonic device, or a piezoelectric element, or ultrasonic sensing device, associated housing and/or sensing devices capable of performing sensing in a fluid environment, such as immersion environments.

The water, liquid, fluid, or couplant flows from inlet couplings 112, 114, through an associated opening 115, which is associated with inlet 114, is shown in **FIG. 2A**, to flow out of hole 122 onto the surface under examination. Inlet 112 also has a similar opening, which is not visible in the figures as presented, but is opposite opening 115.

The dimensions of the hole 122 are determined by the desired flow rate of couplant and the aperture desired for the sensor to perform the ultrasonic scanning/inspection. Thus, the dimension of the hole, or opening 122 is a design choice.

Also shown are two slots 120(a) and(b) that are utilized by the vacuum inlets, and indeed can be considered as part of the vacuum inlet, that provide an area where the fluid, or couplant, or water, is suctioned from the surface outside an area under examination. The positioning of the slots, or channels 120(a) and 120(b) is determined by the desired manner to remove the fluid, liquid or couplant that is outside the region under examination, or scanning, or inspection by the sensing device. The region that is outside inspection includes areas the sensing device is not currently acquiring sensed data from. This region of scanning includes the area that is subject to present evaluation by the sensing device. Fluid not utilized by the sensing device is outside the sensing area.

The fluid or couplant that is not needed for the ultrasonic scanning (outside the location of the wafer under inspection by the sensing device) can be suctioned off by actuating the vacuum inlets to pull the undesired couplant from the surface, facilitated by the use of slots 120(a) and 120(b).. Thus, the slots 120(a) and 120(b) are channels that the vacuum inlets use to suction the fluid, or couplant, from the surface of the bonded wafer pair, or article. The size and shape of these slots (generally 120) is based on the desired suction properties and may be modified for particular desired scanning/inspection processes.

**FIGs. 2A** and **2B** show another example of the disclosure 200 of the coupler 100, as shown in **FIGs. 1A** and **1B****.** The elements shown in **FIG.2A** and **2B** include elements that are similar to the elements shown in **FIG. 1A** and **1B**.

**FIG. 2C** shows the lower surface 118 has port, or orifice, or hole 122 for the sensing components of sensing device 140. Lower surface 118 also has a recessed portion 223 that may be used as a channel to provide a suction path so that couplant can be removed, or suctioned, from an area under the coupler 200. The sensing device, or transducer, 140 is able to sense imperfections, defects or other properties of a surface and/or subsurface, such as the surface or subsurface of a bonded wafer pair, or other article. As shown by the lower surface 118 of coupler 200, the recessed portion 223 may be substantially circular. Thus, **FIG. 2C** shows a bottom view of the circular slot coupler 200 showing the hole 122 for the couplant, such as water, to flow out and create the pressurized film and the slot 223 where the fluid, or couplant, or water is sucked back up.

This hole 122 also provides a path for the ultrasonic waves to travel from the sensor, to the surface of the article, or wafer, or bonded wafer pair under examination, and back to the sensor.

The recessed portion 223 may be sized to accommodate desired suction properties. The dimensions of portion 223 can be determined by the flow rate and force of vacuum inlets 102, 112, 106 and 108, as shown in **FIGs. 1A-C** and **FIGs. 2A-2C** herein. Similar to the discussion herein, couplant may be suctioned off that is not being used to perform the sensing function/ scanning function/ inspection function through the hole 122.

With respect to **FIGs. 1A-1C** and **FIGs. 2A-2C****,** the two fluid, or couplant, inlets 112,114 send a fluid or liquid, such as water, or other couplant, under the sensing device sensing surface, such as a transducer face above orifice 122 and out of the hole 122 at the bottom to create the pressurized film of couplant, such as water, between the bottom of the water coupler (100, 200) and the surface of the sample (sample surface not shown in **FIGs. 1A-1C** or **FIGs. 2A-2C**). As will be apparent to those of skill in the art, the dimensions used herein are based in part on the particular application of the example disclosed.

The dimensions may change based on a different application and are not dispositive of the concepts disclosed herein. The four vacuum inlets 102, 104, 106 and 108 connect to recessed areas (120(a), (b), 223, **FIG. 1C****,** **2C**, respectively,) on the bottom 118 of the coupler (100, 200) outside of the inspection area to remove the couplant (e.g., water) once the couplant is outside of the inspection area of the sensing device (e.g., transducer, or ultrasonic device, which may be any device having a piezoelectric element) on the surface and/or subsurface. These recessed areas (120(a)(b), 223) can vary in design.

This coupler (100, 200) provides that a couplant such as water is present in the inspection area at the time the surface is being inspected by the sensing device, such as a transducer, but practically no couplant is visible by the naked eye, or otherwise discernable by touch, on the surface of the article, such as a wafer, after the area of inspection has been inspected.

While a coupler (100, 200) has been described herein in relation to **FIGs. 1A-1C** and **FIGs. 2A-2C****,** it is also an example of the present disclosure that a chuck may be used to provide suction to an edge, or side of an article, such as a wafer, bonded wafer pair, etc.. This suction may be achieved by utilizing a chuck with a suction cavity that suctions couplant or liquid from the circumference, or edge, of the article, such as a wafer. The chuck, as described herein may be used with or without the coupler (100, 200) as described. The coupler may be used with or without the chuck, as described herein. Indeed, a chuck according to the present disclosure may be used to remove excess fluid or couplant from any suitable inspected surface, and/or edge of an article, such as a sample, or a wafer. Thus, the chuck may be used to collect and/or remove fluid that could wick around the edge of the article and in between areas of the article, such as between the wafers or under the bottom wafer leading to potential water ingression.

As stated above herein, processes to inspect a wafer utilize a couplant, such as water. This means that the wafer could experience brief contact with water along an edge, such as a circumferential edge, of the sample causing water ingression.

Thus, another example of the present disclosure relates to a wafer chuck with a suction ring around a rim, or circumference of the chuck. For example, a chuck designed for 200mm / 300mm wafers may be used, although the principles disclosed herein also apply to chucks designed to support a variety of wafer diameters. The center part is a chuck face with a ring for 200mm wafer support and a ring for 300mm wafer support with corresponding wafer hold down vacuum inlets.

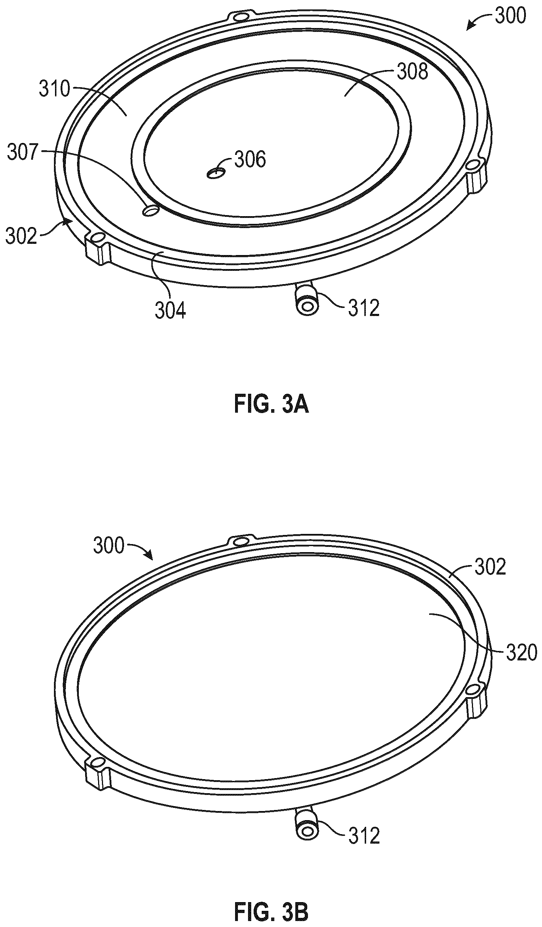

There is also an outer suction ring to remove any liquid, such as couplant or water, that touches the edge of the bonded wafer pair, or wafer sample before the couplant can wick in between or under the bonded wafer pair, or wafer sample, as shown in **FIG. 3A****.** In order to do this the magnitude of the suction force in the outer ring exceeds the magnitude of the wicking force. This means that excess or residual fluid, couplant or water will be suctioned off the wafer edge surface rather than undesirably flowing into the wafer.

Specifically, **FIG. 3A** shows a top view of the wafer chuck 300 with outer support ring 302 that circumscribes inner, or first, vacuum ring area 308 for 200mm wafers and outer, or second, vacuum ring area 310 for 300mm wafers. These vacuum ring areas 308 and 310 are used to secure a wafer, bonded wafer pair or other article in a flat position on the surface of the chuck 300. Vacuum inlets (only inlet 312 is visible in **FIG. 3A**) for each wafer size, and the suction hole 306 (inner vacuum ring area 308) and suction hole 307 (outer vacuum ring area 310) are also shown. An edge suction feature is implemented by providing an edge suction around a circumference of boundary, or support ring 302, as shown by portion 304, which is used to suction couplant, water or other fluid that flows over an edge of a wafer, bonded wafer pair, or other article being inspected and secured on the chuck 300.

**FIG. 3B** shows top view of the wafer chuck 300 of **FIG. 3A**, with outer boundary or support ring 302 with a 300mm bonded wafer sample 320 in place. Vacuum inlet 312 is also shown.

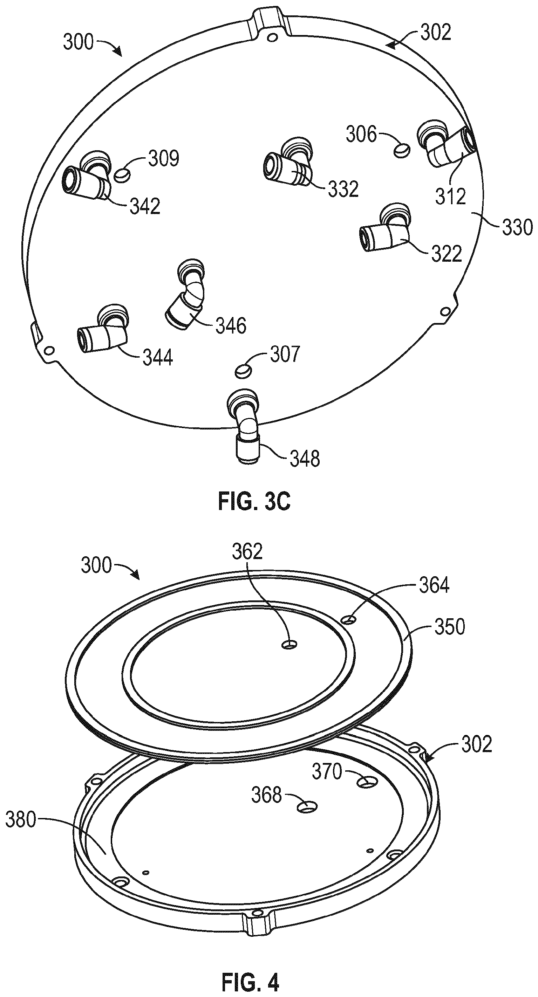

**FIG. 3C** shows bottom view, with lower, or bottom surface 330, of the wafer chuck 300 with outer support ring 302 showing a plurality of wafer holding vacuum inlets and the three water outlets. The number and configuration of the outlets and inlets can vary. Three water outlets 306, 307 and 309 are shown just as an example. The vacuum inlets 312, 322, 332, 342, 344 and 348 are shown.

**FIG. 4** shows one embodiment to create the suction ring around the rim or edge, such as the circumference, of the wafer support chuck. This is achieved by providing vacuum inlets to suction water or couplant from an edge or circumference of an article or wafer. One way to accomplish the desired vacuum inlets on the edge of an article, such as a wafer is by creating a cavity that can be connected to a vacuum inlet. Specifically, **FIG. 4** shows an exploded view of chuck 300 that has two-parts (350, 380) consisting of the upper section (350) that supports the wafer and a lower section (380) that creates the ring cavity for the outer water suction ring, which may be the annular vacuum. Ports 362, 364, 368 and 370 and outer ring structure 302 are also shown.

Ports 362 and 368 in upper section 350 and lower section 380, respectively, align when the upper section 350 is inserted onto lower section 380. Similarly, ports 364 and 370 are also aligned with each other. These ports provide suction to a flat surface of a wafer secured on the chuck 300.

Thus, **FIG. 4** shows the upper 350 disk that supports the wafer (not shown in **FIG. 4**) and allows for wafer hold down, and the lower section 380 supports the upper disk 350 and creates the ring cavity for the water, or couplant to be suctioned from the edge. Thus, when section 350 is inserted into section 380, a cavity is formed in which a vacuum can remove liquid, or couplant, from an edge of the wafer, bonded wafer pair or other article secured on the chuck 300.

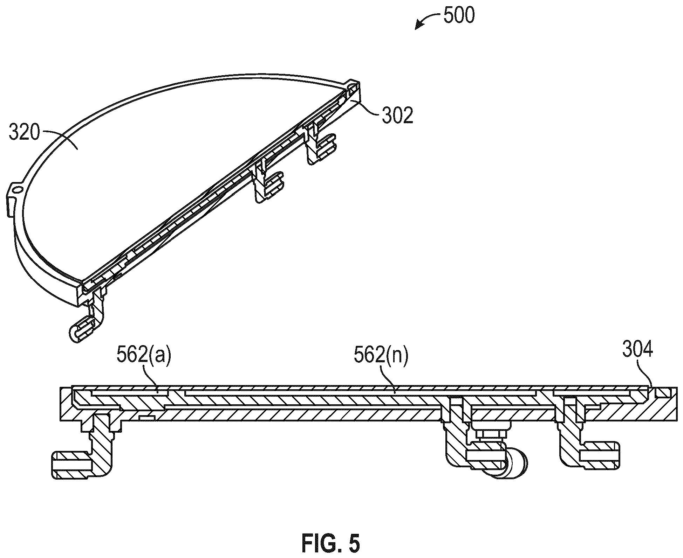

**FIG. 5** shows a cross-section view 500 illustrating the ring cavity. As shown in **FIG. 5** outer boundary or support ring 302 and bonded wafer 320 are shown. Also shown are water, or couplant annular suction chamber 304 that is used to form a suction ring, as described herein, and wafer suction chambers 562(a)...562(n), where "n" is any suitable number. The suction chambers (generally 562) provide a suction force to hold a wafer in a desired position on the wafer chuck, as described herein. Annular suction chamber 304 provides suction for couplant or water that has flowed over an edge of bonded wafer 320 to be suctioned off prior to absorption by or ingression into the bonded wafer 320 along an edge surface of the bonded wafer 320.

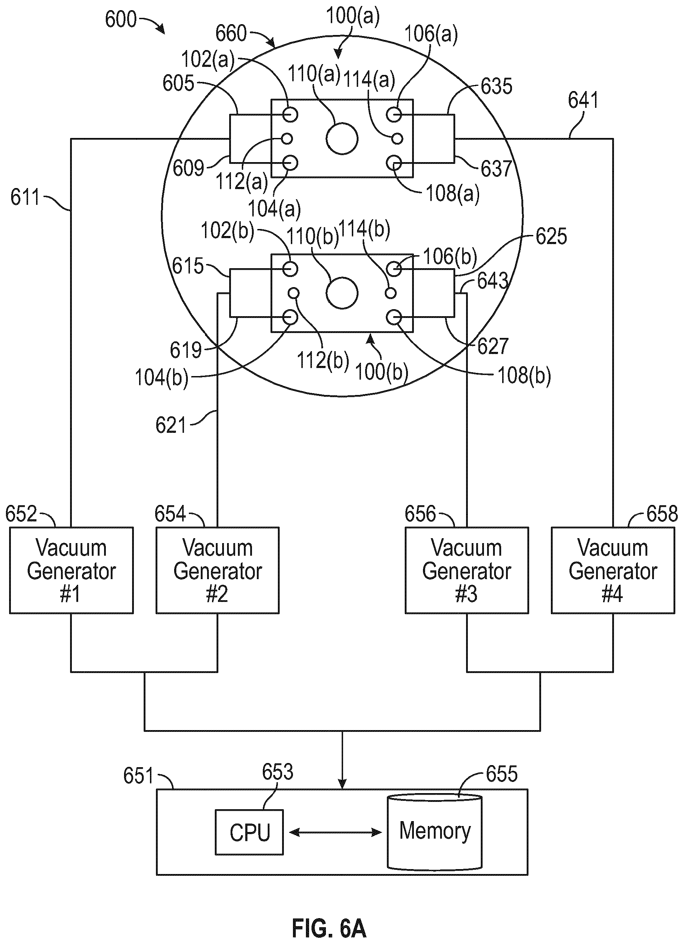

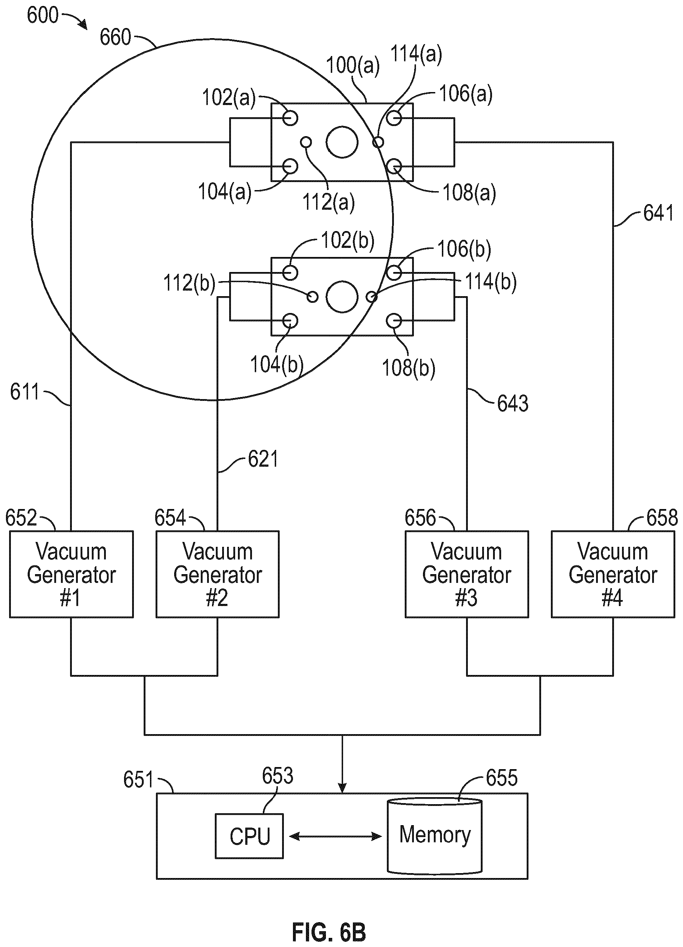

**FIGs. 6A** and **6B** show an example of the disclosure that includes a plurality of vacuum generators. The couplers 100(a) and 100(b) shown in **FIGs. 6A** and **6B** may be used with the chuck (not shown in **FIGs. 6A** and **6B**), which is used to hold, or secure, the wafer during inspection. As is apparent to those of ordinary skill in the art, any suitable chuck may be used. As is apparent to those of ordinary skill in the art, the wafer 660 may be secured by suctioning the wafer 660 to a surface of the chuck shown in **FIG. 5****.**

While **FIGs. 6A** and **6B** show two couplers 100(a) and 100(b), it is an example of this disclosure that any suitable number of couplers may be used. For example, a third coupler could be used in conjunction with the two couplers that are shown. Furthermore, a fourth, or any additional number of couplers could be used to form a second pair or configuration of some number of couplers other than an even number of couplers. The number of couplers is based on a desired system set-up and the illustration of two couplers is merely for discussion purposes. The couplers could also have additional connections, such as tubes, or may be connected to the connections, or tubes of other couplers. These additional couplers may be connected to one or more vacuum generators, depending on the design configuration of the system.

Once held in a desired position on the chuck, which may include application of suction to various portions of the chuck to hold the wafer, the scanning/inspection occurs. The chuck, as described herein is suitable to secure the wafer 660, and may provide an annular vacuum, within a cavity to suction the excess couplant from the edge of the wafer 660.

The example of the disclosure shown in **FIGs. 6A** and **6B** is that when one or more vacuum inlets of the coupler are not in operational position (proximity). Operational position is typically between approximately 0.05mm and 60 mm relative to the wafer surface in the Z-axis, preferably between approximately 0.1 mm and 30 mm relative to the wafer surface in the Z-axis. Thus, the operational position is above a portion of the wafer being inspected. Suction of the vacuum inlets that are in operational position with the wafer surface is not impacted or affected. The vacuum ports or inlets not in operational position to the surface of the wafer will not have any suction, the coupler might lose the suction related to other vacuum inlets.

By having separate vacuum generators associated with each vacuum inlet, the vacuum inlets in proximity (operational position) to the wafer surface maintain a vacuum. The vacuum generator associated with a vacuum inlet that is not in operational position with the wafer surface could be turned "OFF" and then turned back "ON" when the vacuum inlet that was not in operational position with the wafer surface once again becomes in operational position with the wafer surface.

**FIG.** 6A shows an example of the disclosure that has two couplers 100(a) and 100(b) positioned such that all fluid nozzles and vacuum inlets are positioned at an operational position relative to the surface of the bonded wafer pair, or wafer, which is typically between approximately 0.05 mm and 60 mm, preferably between approximately 0.1 mm and 30 mm, above a portion of the wafer being inspected. This operational position of the coupler permits the components (typically the lower surface) of the coupler to interact with the surface of the bonded wafer pair, or wafer such that the couplant is deposited on the surface and the vacuum inlets suction couplant from the surface. These operations are performed when the coupler is positioned at the operational position.

**FIG. 6B** shows that an edge portion of a wafer is being scanned such that some of the fluid nozzles and some of the vacuum inlets are not in the operational position with the wafer surface. Thus, some of the nozzles and some of the vacuum inlets are not in a position to deposit couplant on the surface, nor suction couplant from the surface, respectively.

As shown in **FIG. 6A****,** wafer 660 can be inspected by couplers 100(a) and 100(b). While two couplers 100(a) and 100(b) are shown, any suitable number of couplers could be used. While couplers 100(a) and 100(b) are similar, coupler 100(a) is described in detail. Coupler 100(a) has associated vacuum inlet nozzles, 102(a), 104(a), 106(a) and 108(a). Fluid inlets 112(a) and 114(a) are also shown. Orifice 110(a), for positioning a scanner, or transducer, or other apparatus that may be used to scan the surface of a bonded wafer pair is shown. Connection 605 is connected to vacuum inlet nozzle 102(a) and connection 609 is connected to vacuum inlet nozzle 104(a). Connection, or connectors (605, 609, 611, 635, 637, 641, 615, 619, 621, 625, 627 and 643) are typically tubes, or conduits. These tubes may be made of plastic, PVC (poly vinyl chloride), or other suitable material to operatively connect a vacuum generator to a vacuum inlet. The tubes may be flexible, bendable, and capable of holding a vacuum and not leak fluid, gas, or otherwise prevent the suction force or fluid transmission. Similar tubes, or connectors may be used to connect the couplant, or fluid inlet couplings to a source of couplant (not shown). Connectors or connections 605 and 609 may be combined to connector 611. Connector 611 is coupled to a vacuum generator 652. Vacuum inlets 106(a) and 108(a) are coupled to connections 635 and 637, which may be hoses, or plastic tubing. Connections 635 and 637 may be combined into connection, or tube 641, which is operatively coupled to vacuum generator 658.

Alternatively, a single vacuum generator may be used to control any suitable number of vacuum inlets. Thus, the number of vacuum generators is a design choice based on the configuration of the system. Indeed, one example of the disclosure is eight vacuum generators each connected to a vacuum inlet.

Coupler 100(b) has similar components as those described in relation to coupler 100(a). Coupler 100(b) has associated vacuum inlet nozzles, 102(b), 104(b), 106(b) and 108(b). Fluid inlets 112(b) and 114(b) are also shown. Orifice 110(b), for positioning a scanner, or transducer, or other apparatus that may be used to scan the surface of a wafer is shown. Connection, or connector, 615 is connected to vacuum inlet nozzle 102(b) and connection, or connector, 619 is connected to vacuum inlet nozzle 104(b). Connectors 615 and 619 may be combined to connector 621.

Alternatively, the connectors, as shown herein can be separately connected to a dedicated vacuum generator. Thus, each vacuum inlet (102, 104, 106 and 108) may have an associated vacuum generator. However, as shown, connector 621 is coupled to a vacuum generator 654. Vacuum inlets 106(b) and 108(b) are coupled to connections 625 and 627, respectively, which may be hoses, or plastic tubing. Connections 625 and 627 may be combined into connection, or tube 643, which is operatively coupled to vacuum generator 656.

Vacuum generators 652, 654, 656 and 658 may be operatively coupled to a processing unit 651. The processing unit 651 may include a central processing unit (CPU) 653 bi-directionally operatively coupled to memory, or storage, unit, or module, 655.

The central processing unit (CPU) 651 has adequate processing power to access data from memory, or storage, unit, or module, 655 to operate the vacuum generators 652, 654, 656 and 658. The memory or storage unit 655 is typically suitable electronic storage configured to access program code, either stored locally, and/or remotely. The electronic storage or other suitable storage medium may be a non-transitory, computer readable medium configured to store instructions, that when executed perform a desired function. The electronic storage of module 655 may be RAM, ROM, EEPROM, DRAM, thumb-drive, magnetic disk or other suitable medium to store program code.

Computer storage media includes volatile and nonvolatile, removable and non-removable media implemented in any method or technology for storage of information such as computer readable instructions, data structures, program modules or other data. Computer storage media includes, but is not limited to, RAM, ROM, EEPROM, FLASH memory or other memory technology, CD-ROM, digital versatile disks (DVD) or other optical disk storage, magnetic cassettes, magnetic tape, magnetic disk storage or other magnetic storage devices, or any other medium which can be used to store the desired information and which can be accessed by a computer 310.

The vacuum generators 652, 654, 656 and 658 may be configured to operate individually and/or collectively based on instructions, or commands, from controller 651. Alternatively, the control of the vacuum generators may be manual control, automated control or a combination of manual and automated control. While four vacuum generators are shown, any suitable number could be used as an example of the disclosure. The individual control of each vacuum generator enables selective operation of vacuum inlets, as described herein.

Indeed, **FIG. 6B** shows that during a wafer inspection, or scanning, there are periods of time and inspection areas of the wafer that are enhanced by selective control of the vacuum inlets and fluid inlets. As shown, coupler 100(a) with vacuum inlets 106(a) and 108(a) as well as a portion of fluid inlet 114(a) are outside a surface of the wafer 660. Similarly, some of the vacuum inlets (106(b), 108(b)) of coupler 100(b) are not in operational position of the wafer surface 660. This may be thought of as "off" the wafer, since the coupler, or portions of the coupler do not interface with the wafer surface.

To improve the scanning and/or inspection process, individual control of the vacuum inlets is provided by the selective operation of vacuum generators associated with the vacuum inlets that may not be in operational position with the wafer surface 660. The position of some of the vacuum inlets (106(a), 108(a)) being away from an edge of the surface of the wafer causes the associated vacuum generators to change their operational state. Thus, when a portion of the coupler is not in proximity to the surface, the vacuum generator associated with the off-surface vacuum inlets are turned off. This position can be sensed by the scanner or transducer. Thus, an operational state of a vacuum generator is a function of a position of the associated one or more vacuum inlet couplings. The vacuum generators, operatively coupled to one or more associated vacuum inlet ports, can be operated individually by controller, or computer 651. The other components of **FIG. 6B** has been described in relation to **FIG. 6A****.**

Alternatively, the vacuum generators (652, 654, 656, 658) may be associated with selected ones of the inlets (102(a) and (b), 104 (a) and (b), 106 (a) and (b), 108(a) and (b)). Such an example of the disclosure may include one or more vacuum generators being operatively coupled to inlets such that a particular vacuum generator controls a particular inlet or a single vacuum generator controls two or more inlets. For example, when some vacuum inlets are in a position that is off the wafer surface in the x, y, plane, vacuum inlets that are on the wafer surface in the x, y plane will maintain suction with the wafer surface since those "on" inlets are controlled by other vacuum generators.

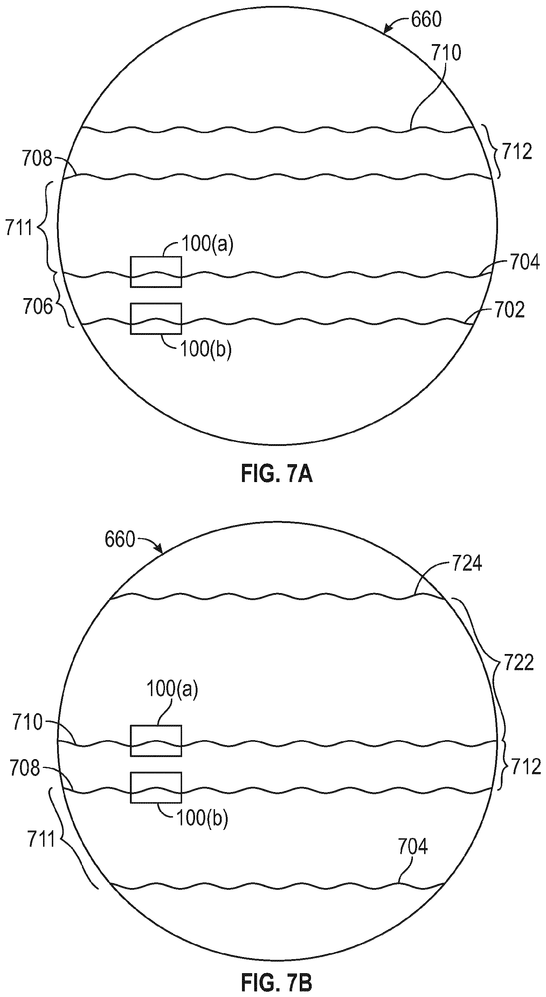

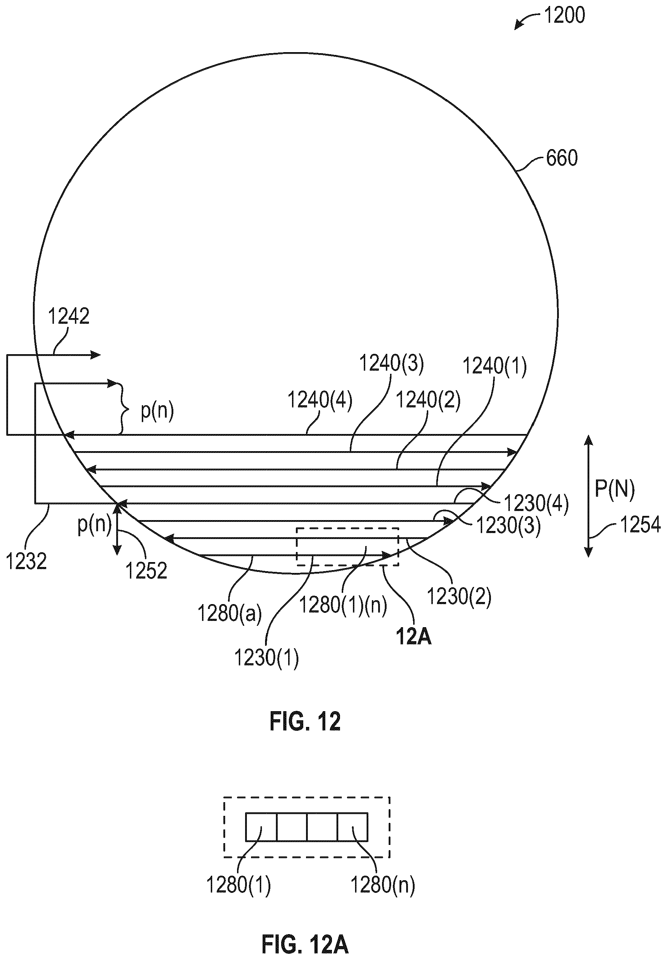

**FIGs. 7A** and **7B** show an example of the disclosure of a pass to remove excess fluid. The process shown in **FIGs 7A** and **7B** is described using a surface of a wafer 660. The wafer may be held, or secured, in place by the chuck, as described herein and scanned/inspected by coupler(s) as described herein. Further description of the movement of the coupler pair vis-a-vis the surface under examination or inspection is provided in relation to **FIG. 12****,** herein.

As shown in **FIG. 7A****,** the wafer surface 660 is shown as a circular surface, although any shaped- surface may be used. The surface 660 has one set of scanning paths, which includes a path 702 for one coupler 100(b) and a path 704 for another coupler 100(a). Paths 702 and 704 are separated by a linear distance 706 along the y-axis of the surface 660. The distance 706 may be defined as a raster scan distance (p₍ₙ₎). Coupler 100(a) is traversing along scan path shown by 704. Coupler 100(b) is traversing along scan path shown as 702. Other scan paths, areas of inspection, are shown as paths 708 and 710. Path 708 is located a distance 711 along the Y-axis from path 704. Paths 708 and 710 are separated by a distance 712 along the Y-axis.

**FIG. 7B** shows that couplers 100(a) and 100(b) are scanning/inspecting along paths 708, 710, respectively. The scanning/inspection process is similar to the scanning/inspection of the other portion of the wafer. The next area of the wafer, after paths 708, 710 is shown by path 724, which is a distance 722 along the Y-axis. (Distances in Figures are not shown to scale.)

As shown in **FIGs. 7A** and **7B****,** the couplers 100(a) and 100(b) can be configured to scan/inspect substantially parallel paths on a wafer secured by a chuck, as described herein. The areas of scanning/inspection are subjected to the introduction of a fluid during the inspection process but the presence of the fluid may not be desired outside an immediate, or currently being inspected area of the wafer.

The couplers 100(a) and 100(b) can repeat the scanning of an area that has recently been inspected to suction fluid, or water that was used during the inspection process. This is achieved by positioning one or more couplers so that subsequent to a scanning/inspection operation, the coupler(s) traverse the path to suction fluid from the wafer surface. Specifically, a coupler (100(a)) can repeat a scan path 704 after the coupler 100(a) scanned the scan path at the same speed without depositing couplant. The repeat pass of scan path 704 by coupler 100(a) is performed without depositing any couplant or liquid and the vacuum inlets are actuated to suction the surface along scan path 704. Thus, a pass is made without actuating the sensing device or fluid inlets, but suctioning fluid from the surface utilizing the vacuum inlets.

Alternatively, the pass path can be repeated at a slower speed using fluid. That is, the scan path will be repeated with deposition of fluid, suctioning and at a slower speed.

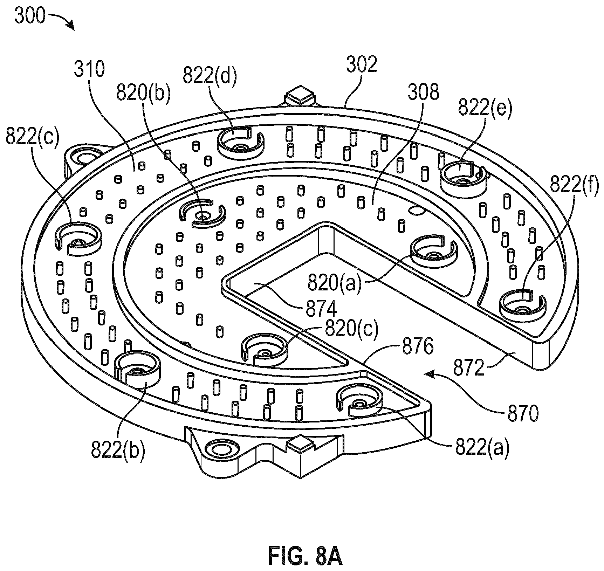

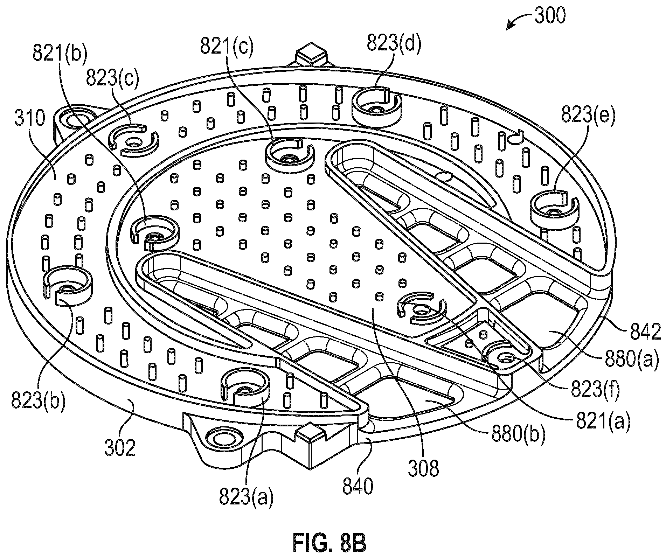

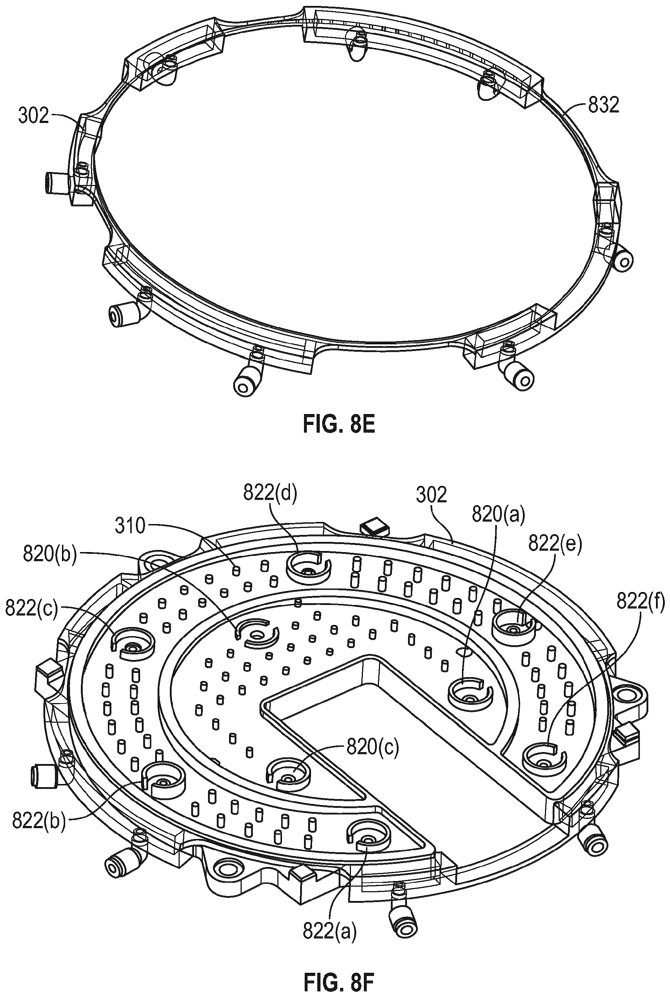

**FIGs. 8A** and **8B** show an example of the disclosure of a chuck having a lift off portion. The chuck may be used to support, or secure, an article, such as a bonded wafer pair, wafer, or other item that is amenable to support. While the example of the disclosure shown in **FIGs. 8A-8F** show a substantially circular chuck, the outer circumference could be any suitable shape or have any suitable perimeter. The use of a substantially circular perimeter is merely for discussion purposes.

**FIG. 8A** shows wafer chuck 300 has vacuum inlets 822(a)... (f) in outer region 310 and vacuum inlets 820(a)...(c) in inner region 308. While some vacuum inlets are shown, any suitable number could be used. The wafer chuck 300 has a portion 870 that includes portions 872, 874 and 876.

When suction is applied to a wafer mounted or supported by the chuck 300 (wafer not shown), the wafer is held in place on the chuck 300. Using the portion 870, which does not contain vacuum inlets, a wafer can be picked-up, or removed from the chuck 300 as well as placed on the chuck 300. Using this example of the disclosure with a carve out portion 870 permits a wafer to be placed on or removed from a surface of the chuck when the suction has been turned "OFF". Additionally, the outer support ring 310 may contain sections. One or more of these sections may be raised or lowered vertically to permit removal of the bonded wafer pair.

**FIG. 8B** shows wafer chuck 300 has vacuum inlets 823(a)...(f) in outer region 310 and vacuum inlets 821(a)... (c) in inner region 308. While some vacuum inlets are shown, any suitable number could be used. The wafer chuck 300 has portions 880(a) and (b) that are configured to be used for article removal. Using this example of the disclosure with carve out portions (840 and 842) permits a wafer to be placed on or removed from a surface of the chuck when the suction has been turned "OFF". The similar elements have been described in relation to **FIG. 8A** above. The region 880(a) includes 842, which is a section of ring 302 that has a smaller portion that facilitates removal of an article, or wafer. The region 880(b) includes 840, which is a section of ring 302 that has a smaller portion that facilitates removal of an article, or wafer. As shown in **FIG. 8B****,** the two regions 880(a) and (b) provide an area of reduced or lower suction for removal of a wafer.

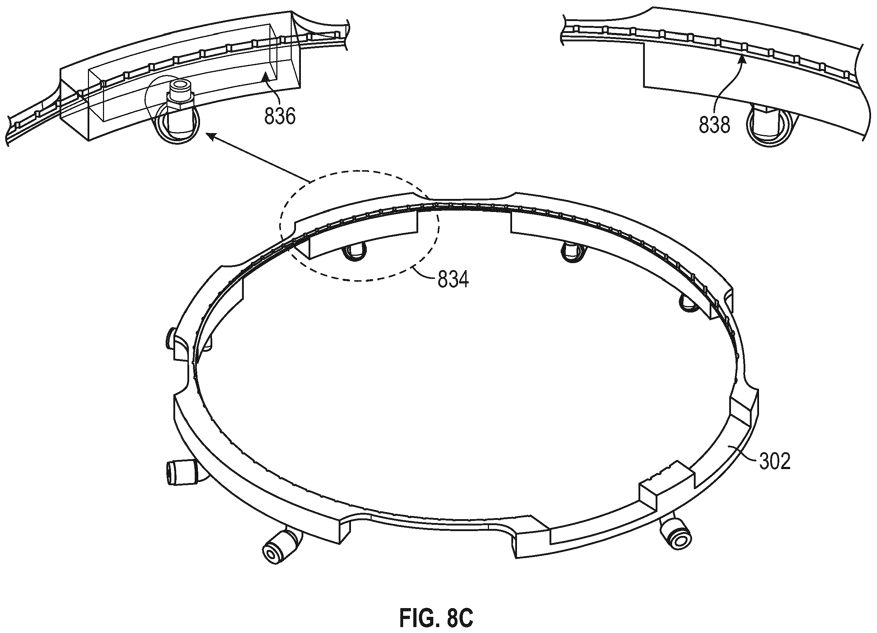

**FIG. 8C** shows the ring 302 having portion 834 with chamber 836. The ring 302 also includes vacuum channel paths, generally 838.

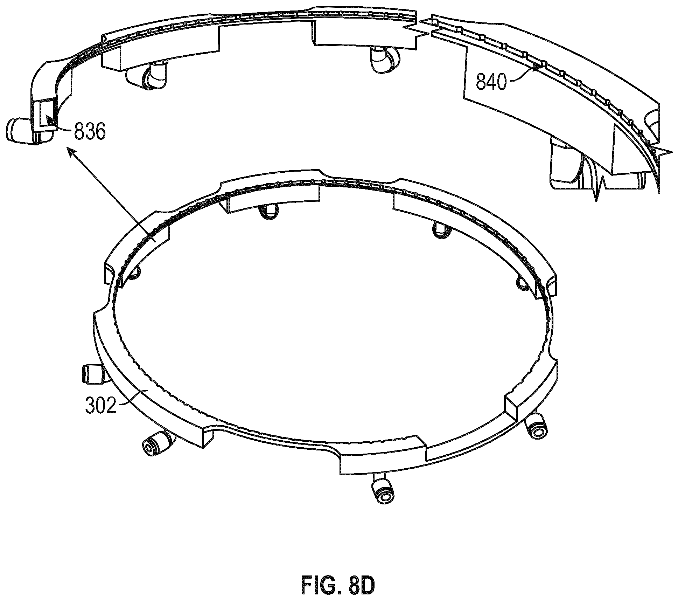

**FIG. 8D** shows another view of ring 302, vacuum chamber 836 and vacuum slits, generally 840.

**FIG**. **8E** shows ring 302 with cavity 832 that provides a location for the chamber (shown as 836 herein).

**FIG. 8F** shows an example of the disclosure of the chuck with ring 302. The other elements of **FIG. 8F** have been described previously herein.

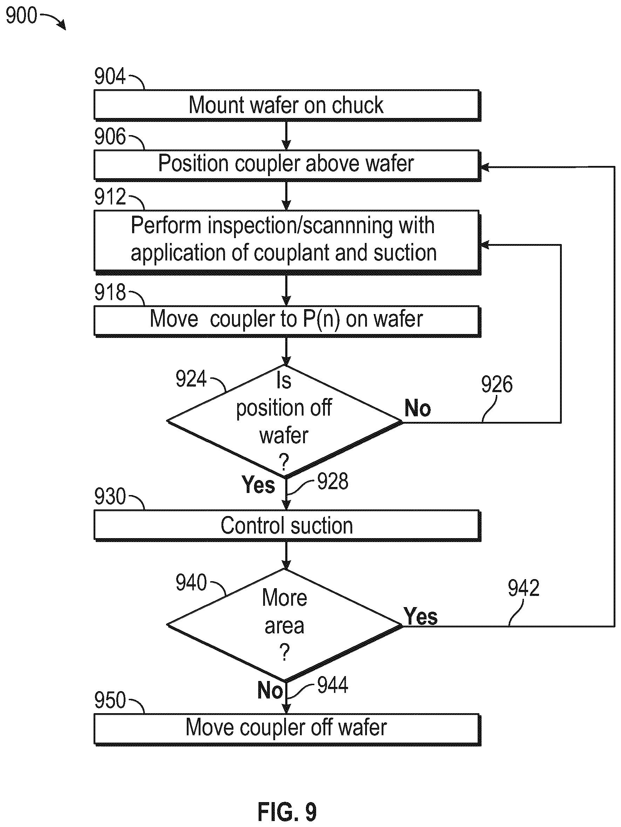

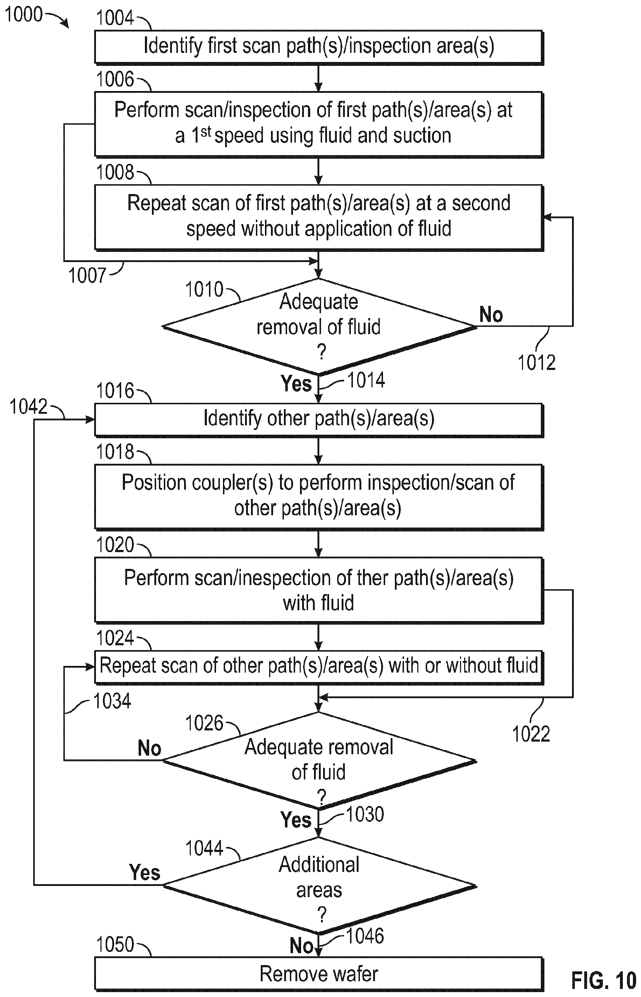

**FIGs. 9** and **10** and **11** describe methods, or procedures 900, 1000, 1100, respectively, to operate an apparatus to inspect and/or scan ("inspect/scan") at least a portion of a bonded wafer pair, or wafer, surface and/or at least a portion of a bonded wafer pair, or wafer, subsurface, or internal layers, (methods 900, 1000) and to secure an article, such as a wafer, to a chuck (method 1100). These methods, or procedures 900, 1000 and 1100 may be described in terms of steps that result from execution of instructions stored on a computer-readable medium. The execution of the instructions may be used to control an associated apparatus or component of an apparatus.

These computer program instructions may be provided to a processor of a general purpose computer, special purpose computer, or other programmable data processing apparatus to produce a machine, such that the instructions, which execute via the processor of the computer, or other programmable data processing apparatus, create means for implementing the functions/acts specified in the flowchart and/or block diagram block or blocks. These computer program instructions may also be stored in a computer-readable medium that can direct a computer or other programmable data processing apparatus, to function in a particular manner, such that the instructions stored in the computer-readable medium produce an article of manufacture including instruction means which implement the function/act specified in the flowchart and/or block diagram block or blocks.

The computer program instructions may also be loaded onto a computer or other programmable data processing apparatus (shown as processor 651, herein) to cause a series of operational steps to be performed on the computer, or other programmable apparatus to produce a computer-implemented process such that the instructions which execute on the computer or other programmable apparatus, provide processes for implementing the functions/acts specified in the flowchart and/or block diagram block or blocks.

The computer-readable medium may be a non-transitory computer-readable medium, or any suitable medium that stores instructions in an electronic memory and executed by a processor, which accesses the instructions. These types of electronic storage and electronic memories may be RAM (random access memory), ROM (read only memory), EEPROM. For example, the instructions may be stored in memory 655 and executed by CPU 653, as shown in **FIG. 6A** and **FIG. 6B** herein.

The present examples of the disclosure are described below with reference to flowchart illustrations and/or block diagrams of methods, apparatus, systems and computer program products according to examples of the disclosure. It will be understood that each block of the flowchart illustrations and/or block diagrams, and combinations of blocks in the flowchart illustrations and/or block diagrams, can be implemented by computer program instructions.

**FIG. 9** shows an example of the disclosure of a method 900 to utilize the coupler in conjunction with the chuck. As shown in **FIG. 9**, a method 900 is described to operate a chuck and a coupler to mount a wafer, perform a scanning, or inspection, operation and remove the wafer from the chuck.

A wafer is mounted on a chuck (904) and a coupler apparatus, typically having two coupler units is positioned slightly above an area of the wafer. This area above the wafer is an initial location to begin the scanning/inspection operation. This initial position on the wafer can be defined as "initial position", which is typically approximately between 0.05 mm and 60 mm, preferably between approximately 0.1mm and 30 mm from the surface of the wafer being scanned/inspected (906). This distance from the bonded wafer pair, or wafer surface is referred to herein as the operational distance. Thus, the scanner, sensor, or transducer, is positioned to obtain an optimal scan/inspection of the wafer surface, subsurface, internal layers and/or intermediate layers. Therefore, while the above-cited distance range is optimal, other distances from the wafer surface are also an example of the disclosure.

The coupler apparatus, typically having two couplers, performs the inspection/scanning operation with application of couplant and suction (912). This inspection/scanning operation goes from first initial position (P₍₁₎) to a second area P₂ up to any number of locations (P_{(N)} where "N" is any suitable number, or location on the wafer, which is a position on the wafer). This position could be defined by an "X" "Y" coordinate pair.

During the inspection/scanning operation, suction can be applied to portion(s) of the bonded wafer pair, or wafer that was either previously the area of the inspection/scanning or a current area of inspection, but is outside the sensor circumference. This suction step is a process by which the coupler(s), when being moved over a surface of the wafer, permit the vacuum inlets remove excess fluid, or couplant, by suctioning the fluid, or couplant, from the surface of the wafer.

Following the inspection/scanning of the first area (P₁) (912), the coupler is moved to a second position, which could be any subsequent position (P₂ through P_{N}) on the wafer surface (918). A determination is made whether or not any portion of the coupler is located off the wafer in the X or Y plane, since the coupler distance to the surface of approximately 0.05 mm to 60 mm is in the Z plane (924). If not, "no" (926) shows that the inspection/scanning operation continues by applying fluid and suction to the wafer surface at the position of the coupler (912).

If a portion of the coupler is "off" the wafer surface in either the X or Y plane, "yes" (928) shows that the suction of one or more vacuum inlets is controlled (930). This control may be achieved by turning the associated vacuum generator to an "off" state, while maintaining suction at other vacuum inlets.

Alternatively, if a portion of the coupler is not in operational position along the X or Y axis position, the vacuum inlet(s) that are off the surface in the X plane or Y plane position have limited suction force. However, the other vacuum inlets, controlled by different vacuum generators, will provide suction to the inlets in operational position relative to the surface of the wafer.

In an example the various vacuum generators may be optionally controlled to provide a vacuum suction to selected vacuum inlets depending on the position of the vacuum inlet. Thus, it is optional whether the vacuum generator associated with any vacuum inlet actually turns off the suction force to an associated vacuum inlet when the vacuum inlet is not on the surface in the X or Y plane of the surface.

A determination is made whether additional areas of the wafer are to be inspected/scanned (940). If so, "yes" (942) shows that inspection/scanning is performed by positioning the coupler at a desired location (906).

If there are no other areas of the wafer to be scanned/inspected, "no" (944) shows that the coupler is moved off the wafer in the Z plane so that another wafer may be inspected (950).

**FIG**. **10** shows a method 1000 to implement an example of the disclosure. Scan paths, or inspection areas, are identified (1004). These scan paths, or inspection paths are typically areas that one more coupler(s) will traverse during a scan or inspection swath. An inspection/scanning operation of the first scan path(s)/inspection area(s) is performed at a first speed (1006). This inspection scan typically utilizes application of a fluid as well as suction, to suction fluid that is outside the inspection area or scan scope that is being examined by a scanner, or transducer, as described herein.

The area scanned by the coupler can be identified and re-scanned by the coupler (1008). This re-scanning process utilizes suction with or without application of fluid. This re-scan may be performed to remove residual fluid that is present on the wafer surface and is performed at a second speed. The second speed may be the same velocity as the first speed or different, either less than the first speed or greater than the first speed.

Alternatively, line 1007 shows that the suctioning pass may be skipped and following an inspection scan using fluid and suction a determination is made (1010).

A determination is made whether there has been an adequate removal of fluid (1010). This may be determined whether or not there was a suctioning pass (1008), or no suctioning pass (1007, from 1006). If there has not been an adequate removal of fluid, "no" (1012) shows that the area is scanned again to suction fluid.

If it is determined that adequate fluid has been removed, "yes" (1014) shows that other scan path(s)/inspection area(s) are identified (1016). These scan path(s)/inspection area(s) may be other inspection areas on the wafer.

The one or more coupler(s) are positioned such that the one or more coupler(s) scan/inspect the wafer surface in other wafer areas (1018). The scan/inspection of other path(s)/area(s) of the wafer surface is performed by the one or more couplers (1020). This scan/inspection is performed with application of fluid and suction, similar to the previous scan (1006).

A second, or repeat, scan of the second (other) area may be performed (1024). This repeat scan may be performed with or without fluid and is used to suction off excess, or residual, fluid or couplant, or liquid, from the surface of the wafer. The speed of the coupler during this second, or repeat, scan may be the same or different than an inspection scan procedure.

For example, there are various operational examples of the disclosure. One example of the disclosure (without fluid) is that a second pass of the same path is performed. This second pass may be performed at the same speed as the previous pass and the fluid deposition is not activated. Thus, the coupler does not deposit fluid, but utilizes the suction capability to remove excess fluid.

Another example of the disclosure (with fluid) is that the coupler performs a second pass over the previously scanned path and deposits fluid. This pass is performed at a slower speed than the initial pass. The slower speed permits the vacuum inlets to suction off excess fluid since the vacuum inlets are exposed to a portion of the surface for a longer period of time.

Alternatively, the second, or repeat suction scan (1024) may be skipped (1022) and a determination may be made (1026) whether there was an adequate removal of fluid, couplant, or water, without performing a suction scan (1022).

Depending on the result of sensing the amount of residual fluid, or couplant, or water, on the surface of the wafer (1026), the suction scan (1024) may be repeated when there is not an adequate removal of fluid or water, or couplant (1034).

If there has been an adequate removal of fluid, or water, or couplant (1030) a determination is made whether there are additional areas of the wafer to be examined, or inspected, (1044). If so, "yes" (1042) shows that an identification of other scan path(s)/inspection area(s) of the wafer is performed (1016). The additional areas of the wafer are inspected/scanned as described from that point (1016).

If there are no additional areas of the wafer to be examined (1046), an inspection of another wafer may be initiated (1050).

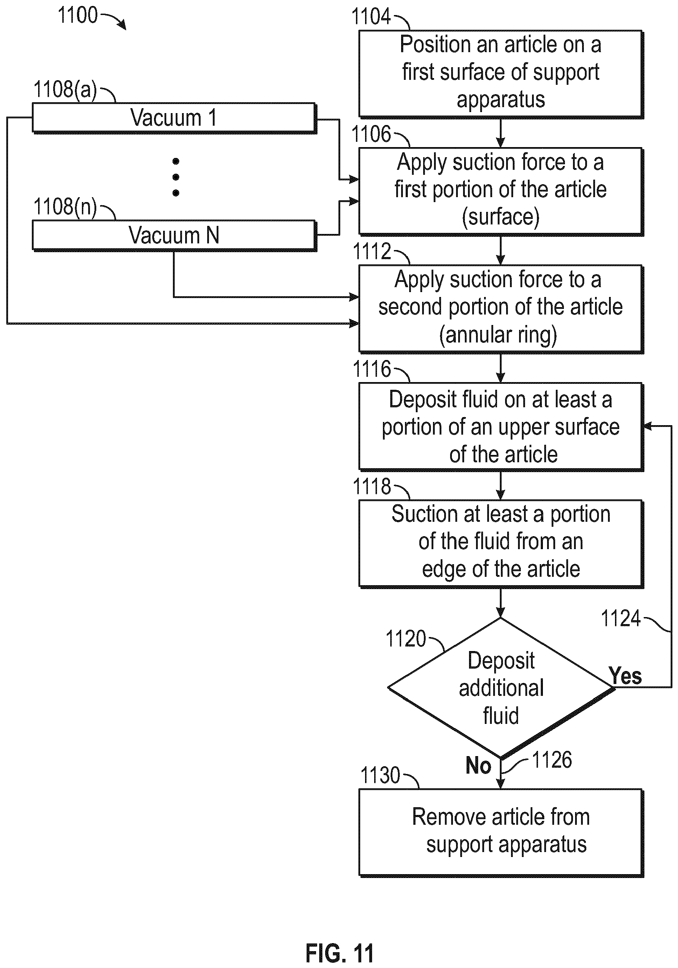

**FIG. 11** shows a series of steps, or instructions 1100 to control operation of a support apparatus, such as a chuck. The chuck may be used to secure a wafer that is inspected and/or scanned by a coupler, as described herein. Indeed, the use of the chuck with a cavity to suction excess couplant has a complementary relationship with the coupler that performs a suction scan to suction excess couplant from the surface of the wafer. An article, such as a wafer, is positioned on a first surface of a support apparatus, such as a chuck (1104). The article may be positioned on a flat surface of the apparatus such that the article can be held in a desired position.

A suction is applied to a first portion of the apparatus (1106). This suction is typically applied by controlling one or more vacuums (1108(a)...(n), where "n" is any suitable number). The suction may be applied to the underside of the apparatus at designated, or selected areas, thereby holding the article, such as a wafer, in a fixed position on the apparatus, or chuck. The application of the suction may be controlled by controlling one or more vacuum generators that produce a suction force to an associated one or more vacuum inlets, as described herein.

A vacuum force, or suction may be applied to a second portion of the apparatus, such as a chuck, to secure the article in a different mode (1112). This suction may be produced by a vacuum inlet on a ring that surrounds the wafer, or bonded wafer pair around the circumference of the wafer. This additional suction may be applied by a vacuum inlet in cooperation with one or more vacuum generators (1108), this second vacuum may be a suction force to pull the fluid that has flowed over an edge of the bonded wafer pair and would otherwise be absorbed by ingress into an edge portion of the bonded wafer pair or wafer. This edge vacuum force pulls or suctions the overflowed fluid from the edge of the bonded wafer pair, or wafer.

This control of vacuums (1106, 1108, 1112) may use any combination of vacuum inlets and vacuum generators to produce the suction that is desired on portions of the article, or wafer. This may include surface (1106) and annular (1112) vacuum forces.

A fluid, such as water, or other suitable couplant, is deposited on at least a portion of the article (1116). This deposition of fluid or couplant is typically performed as part of a scanning or inspection function. The fluid, or couplant, is used in conjunction with a scanner to identify imperfections or areas of defects on the article or in the interior of the article, such as a subsurface of a bonded wafer pair, or wafer. At least some of the fluid or couplant is suctioned from an edge by vacuums that may be located in a cavity of the support apparatus (1118).

A determination is made whether to deposit additional fluid on the article, such as a wafer (1120). If so, "yes" (1124) shows that fluid or couplant is deposited on the article (1116). If the determination is made (1120) that no additional fluid is to be deposited, "no" (1126) shows that the article is removed from the support apparatus (1130).

**FIG. 12** shows a representation 1200 of coupler scanning and movement. This may include raster scanning over an area p₍ₙ₎ as well as scanning over another area P_{(N)}.

As shown in **FIG. 12****,** a representation 1200 of an article surface 660, such as a wafer or bonded wafer pair has indications of raster lines, or scan paths, for a first coupler 1230_{(1)...(4)} and raster lines for a second coupler 1240_{(1)...(4)}. While four raster lines, or paths are shown for each coupler 1230_{(1)...(4)}, 1240_{(1)...(4)}, any suitable number of raster paths, or scan paths or lines is within the scope of this disclosure.

Typically, each raster line or scan path 1230, 1240 has multiple collection locations. For example, scan line 1230(₁) has a plurality of collection locations 1280(a)...(n), where "n" is any suitable number. These raster areas are the subject of inspection by a sensing device as described herein.

The raster lines, or scan paths are separated by a distance p₍ₙ₎ 1252. A first coupler will scan, or traverse scan paths 1230(₁) ..₍₄₎ and a second coupler will scan, or traverse paths 1240_{(1)...(4)}, each raster path, or scan path being separated by a distance p₍ₙ₎ relative to the Y axis. The use of a suction only pass, as described herein, may or may not occur depending on a fluid or couplant volume detected or sensed on the surface of the wafer.

When a fist coupler completes scan path 1230₍₄₎, the second coupler completes scan path 1240₍₄₎. The first coupler will move, or change, its position or "jump" a distance P_{(N)} 1254, as shown by 1232. The second coupler will also move, or jump a distance P_{(N)} 1254, as shown by 1242. Thus, the first coupler begins a new scan path on the portion of the article, or wafer surface 660 at the next p₍ₙ₎ position above the last scan path of the second coupler. This location can be defined as 1240₍₄₎ plus p₍ₙ₎ 1252. Thus, the entire surface area of the article or bonded wafer pair 660 is scanned by either the first coupler or the second coupler. Additional scans may be performed without applying fluid and utilizing the suction as desired. Also, additional scans may be performed at a slower speed with fluid, as desired. It is also an example of the disclosure that an additional scan may be performed at a slower speed without fluid.

The use of a suction scan, whether performed at a slower speed, faster speed, with application of fluid or without application of fluid, or any permutation of speed and application of fluid, is described herein. The examples of the disclosure described herein may use any combination of: suctioning; speed of coupler; and application of couplant to optimally perform a scanning procedure of a surface of an article such that the article does not suffer from surface defects and/or subsurface defects due to exposure to fluid introduced and used in the scanning process.

Typically, it is convenient to perform a suction scan on the iteration before a jump 1254. Thus, as shown in **FIG. 12****,** a suction scan would be performed on scan paths 1230₍₄₎ and 1240₍₄₎.

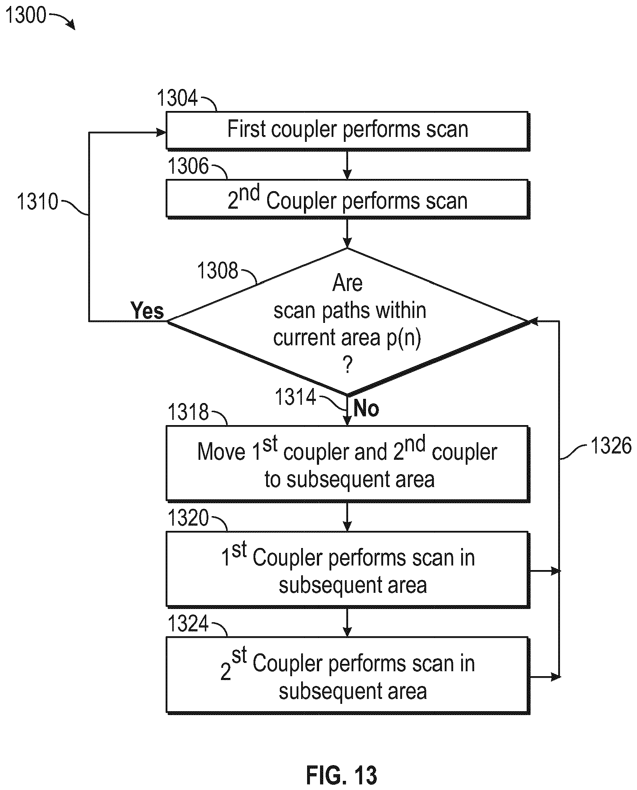

**FIG. 13** shows a flowchart 1300 to control positioning of a pair of couplers according to an example of the disclosure described herein. The description of **FIG. 13** describes two couplers being positioned; however, the utilization to position any number of couplers would be substantially similar. A first coupler performs a first scan or inspection path (1304). A second coupler performs a first scan or inspection path (1306). A determination is made whether the couplers are operating on a certain area of the article (1308). This area may be thought of p₍ₙ₎, which is a scan area of a first set of couplers prior to "jumping" or moving to another area by P_{(N)}.

If the couplers are still scanning an area (p₍ₙ₎), "yes" (1310) shows that the couplers continue to scan/inspect the area of their respective paths.

When the couplers have completed a scan of the area, which may be thought of as p₍ₙ₎, "no" (1314) shows that the first coupler and the second coupler can be moved to another position to scan/inspect another area of the article, or wafer (1318). This other area location can be thought of as a position at P_{(N)} relative to the Y-axis.

The scanning/inspection process then begins at a second area by the first coupler (1320) and the second coupler (1324). After each scan, such as a raster scan, as described herein, a determination is made whether the area is within the current scan area (1308). Thus, the couplers are moved when scanning in an area, such as p(n), is complete. The process then continues until the desired surface has been scanned/inspected.

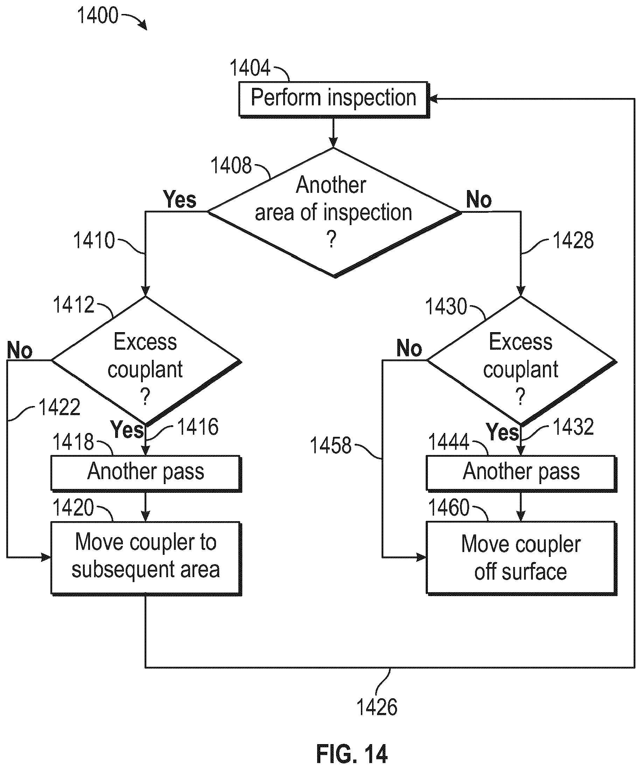

**FIG. 14** shows a flowchart 1400 to remove couplant, such as water, or other suitable fluid, from a surface of a bonded wafer according to an example of the disclosure described herein. An inspection is performed of an article, such as a surface of a bonded wafer pair (1404). This inspection includes deposition of the couplant, sensing the surface and/or subsurface of the article and suctioning the couplant from an area where the couplant is not being used by the sensor to perform the sensing. A determination is made whether there is another area that is desired to be sensed by the sensing device (1408). If there are additional areas to be scanned or sensed, "yes" (1410) shows that a determination is made whether there is additional couplant on the surface (1412). If there is additional couplant on the surface, "yes" (1416) shows that another pass of the coupler is performed (1418). This pass by the coupler may be performed with suctioning and without depositing additional couplant.

Alternatively, the pass (1418) may include deposition of couplant as well as the suctioning process. The coupler is moved to a subsequent (second, third, etc.) area (1420). Once in the subsequent area has been identified (1426), the inspection is continued (1404).

If there is not extra, or undesired couplant (1412), "no" (1422) shows that the movement to a subsequent area is done (1420).

Referring back to determination of whether there are additional areas to be scanned (1408), when there is not another area on the surface to be scanned, "no" (1428) shows that a determination is made whether there is excess fluid on the surface (1430). If so, "yes" (1432) shows that another pass is performed (1444). This pass (1414) may be a suction pass only, which is used to suction excess fluid from the surface. If the determination is made that there is not excess fluid on the surface of the wafer, "no" (1458) shows that the coupler may be moved off the surface of the article (1460).

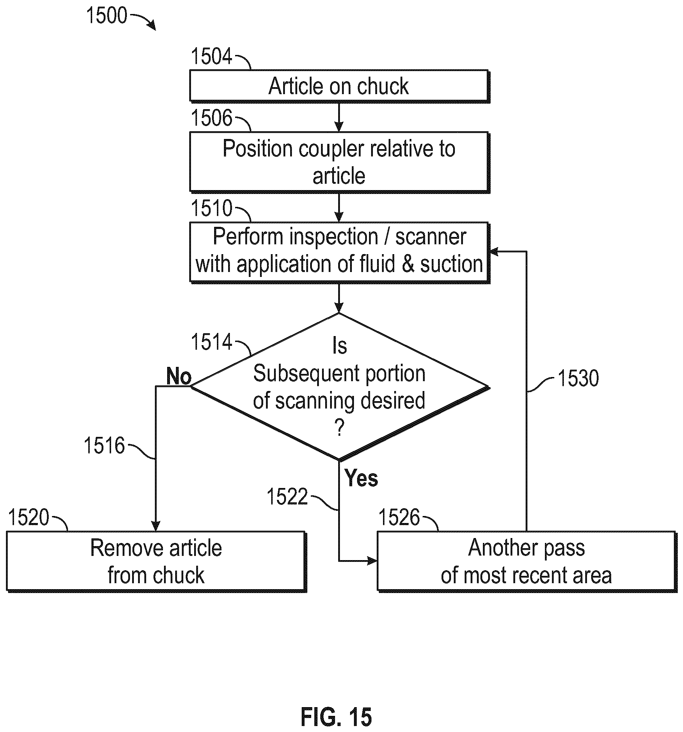

**FIG. 15** shows a flowchart 1500 to remove couplant from a surface of an article, such as a bonded wafer pair, wafer, or other item. **FIG. 15** shows another example of the disclosure described herein. An article, such as a bonded wafer pair, or wafer, is placed on a chuck, or other suitable mounting device (1504). A coupler, such as the coupler described herein, is positioned in an operational position relative to a surface of the article (1506). This operational position is typically between approximately 0.05mm and 45 mm above the surface of the article, in the Z-plane. Preferably, this operational position is between approximately 0.1 mm and 15 mm above the surface of the article in the Z-plane. The operational distance is a distance adequate for deposition of couplant, inspection of the surface and suctioning couplant from the surface of the article.

Once in a desired operational position relative to the article surface, inspection/scanning of the surface occurs by application of fluid and suctioning of fluid, such as couplant (1510).

A determination is made whether another (subsequent) portion of the article is desired to be scanned (1514). If there is, "yes" (1522) shows that another scan path is performed of the most recent area of the article (1526). This scan path may be performed utilizing suction without deposition of fluid. Following the suction path (1530), the inspection/scanning over a subsequent area is performed (1506).

If it is determined that there is not a subsequent portion of the article that is desired to be inspected/scanned (1514), "no" (1516) shows that the article is removed from the chuck (1520).

Various examples of the disclosure are described that may include combinations of examples.

One example of the disclosure is directed to a coupler that includes a sensing device disposed on a first portion of the coupler, the sensing device configured to perform sensing of a plurality of areas of inspection of an article; one or more couplant inlet couplings disposed on a second portion of the coupler, the couplant inlet couplings configured to provide a couplant to a portion of the article that is being inspected by the sensing device; and one or more vacuum inlet couplings disposed on a third portion of the coupler, at least one of the one or more vacuum inlet couplings configured to provide suction through a recessed portion of a lower surface of the coupler to remove at least a portion of the couplant outside the location of the article under inspection by the sensing device.

Another example of the disclosure is directed to the coupler described above and further comprising one or more vacuum generators, each vacuum generator being operatively coupled to an associated one or more of the vacuum inlet couplings.

Yet another example of the disclosure is directed to coupler described above where an operational state of a vacuum generator is a function of a position of the associated one or more vacuum inlet couplings.

Yet another example of the disclosure is directed to coupler described above where a lower portion of the coupler is positioned between approximately 0.1 millimeters to approximately 50 millimeters above an upper surface of the article.

Yet another example of the disclosure is directed to coupler described above where the one or more couplant inlet couplings provide the couplant to a location under a sensing portion of the sensor to create a pressurized film of couplant between the sensing portion of the sensor and the portion of the article subject to inspection.

Yet another example of the disclosure is directed to coupler described above where the couplant is selected from the group consisting of water, deionized water, and reverse osmosis water.

Yet another example of the disclosure is directed to coupler described above where the couplant is water having a temperature between 30 degrees Celsius and 45 degrees Celsius.

Yet another example of the disclosure is directed to coupler described above where the sensing device accumulates inspection data during the sensing and provides the accumulated inspection data to a processor.

Yet another example of the disclosure is directed to an inspection system that includes a first sensing device disposed on a first portion of a first coupler, the first sensing device configured to perform sensing of areas of inspection of an article associated with the first sensing device; a first set of one or more couplant inlet couplings disposed on a second portion of the first coupler, the first set of couplant inlet couplings configured to provide a couplant to a portion of the article inspected by the first sensing device; a first set of one or more vacuum inlet couplings disposed on a third portion of the first coupler, at least one of the first set of vacuum inlet couplings configured to provide suction through a recessed portion of a lower surface of the first coupler to remove couplant outside the portion of the article inspected by the first sensing device; a second sensing device disposed on a first portion of a second coupler, the second sensing device configured to perform sensing of areas of inspection of the article associated with the second sensing device; a second set of one or more couplant inlet couplings disposed on a second portion of the second coupler, the second set of couplant inlet couplings configured to provide a couplant to a portion of the article inspected by the second sensing device; a second set of one or more vacuum inlet couplings disposed on a third portion of the second coupler, at least one of the second set of one or more vacuum inlet couplings configured to provide suction through a recessed portion of a lower surface of the second coupler to remove couplant that is outside the portion of the article inspected by the second sensing device.

Yet another example of the disclosure is directed to the inspection system described above further comprising one or more vacuum generators, each vacuum generator operatively coupled to an associated set of vacuum inlet couplings.

Yet another example of the disclosure is directed to the inspection system described above where an operational state of a vacuum generator is a function of a position of the associated set of vacuum inlet couplings.

Yet another example of the disclosure is directed to the inspection system described above where the first coupler and the second coupler are positioned at a first and second position on the article, respectively, and the first and second coupler inspect associated portions of the article and the first and second coupler suction couplant from the article.

Yet another example of the disclosure is directed to the inspection system described above where the first and second coupler are positioned at a third and fourth position on the wafer, respectively.

Yet another example of the disclosure is directed to a method utilizing two couplers comprising positioning a first coupler at a first location above an upper surface of an article; positioning a second coupler at a second location above the upper surface of the article; dispensing a couplant from one or more of the first coupler and the second coupler onto a portion of the upper surface of the article; scanning a portion of the article by controlling positioning of the first and second couplers; and suctioning at least a portion of the couplant from the upper surface of the article based on the positioning of the first and second couplers.

Yet another example of the disclosure is directed to the method utilizing two couplers further including accumulating inspection data from the scanning step; and processing the accumulated inspection data.

Yet another example of the disclosure is directed to the method utilizing two couplers further comprising: identifying a previously scanned portion of the article; and positioning the first and second couplers to traverse the previously scanned portion of the upper surface of the article while actuating one or more vacuums.

Yet another example of the disclosure is directed to the method utilizing two couplers further comprising: traversing the previously scanned portion of the article at approximately the same rate as the scanning.

Yet another example of the disclosure is directed to the method utilizing two couplers further comprising: depositing couplant on the article; and traversing the previously scanned portion of the article at a slower rate than the scanning.

Yet another example of the disclosure is directed to the method utilizing two couplers further comprising: positioning the first coupler at a third location of the article; positioning the second coupler at a fourth location of the article; dispensing the couplant from one or more of the first coupler and the second coupler onto an associated portion of the article based on the third location and fourth location; scanning an associated portion of the article by controlling positioning of the first and second couplers; and suctioning at least a portion of the couplant from the article based on the positioning of the first and second couplers; the third location being an area between the second position and the fourth location that is an unexamined area of the article.

Yet another example of the disclosure is directed to the method utilizing two couplers where the third position is between approximately 30 and 70 millimeters from the first location along a Y-axis of the article.

Yet another example of the disclosure is directed to the method utilizing two couplers where the first and second couplers are positioned between approximately 0.1 millimeters to 50 millimeters above the upper surface of the article.

Yet another example of the disclosure is directed to method utilizing one coupler comprising: positioning a coupler at a first location above an upper surface of an article; dispensing a couplant from one or more couplant inlet couplings onto a portion of an upper surface of an article; scanning a portion of the article by controlling positioning of the coupler; and suctioning at least a portion of the couplant from the upper surface of the article based on the positioning of the coupler.

Yet another example of the disclosure is directed to method utilizing one coupler comprising accumulating inspection data from the scanning step; and processing the accumulated inspection data.

Yet another example of the disclosure is directed to method utilizing one coupler comprising identifying a previously scanned portion of the article; and positioning the coupler to traverse the previously scanned portion of the upper surface of the article while actuating one or more vacuums of the coupler.

Yet another example of the disclosure is directed to method utilizing one coupler comprising traversing the previously scanned portion of the article at approximately the same rate as the scanning; and suctioning at least a portion of the couplant from the upper surface of the article.

Yet another example of the disclosure is directed to method utilizing one coupler further comprising: depositing couplant on the article; traversing the previously scanned portion of the article at a slower rate than the scanning; and suctioning at least a portion of the couplant from the upper surface of the article.

Yet another example of the disclosure is directed to a chuck apparatus comprising: a first section configured to support at least a portion of an article; one or more first vacuum inlets disposed in one or more regions of the first section; a second section configured to create an annular ring around a circumference of the article; and one or more second vacuum inlets disposed in the annular ring configured to provide suction along the circumference of the article.

Yet another example of the disclosure is directed to the chuck apparatus as described above where the first section comprises two or more regions, each region of the first section having one or more associated ones of the one or more first vacuum inlets.

Yet another example of the disclosure is directed to the chuck apparatus as described above where the second section comprises a structural ring member having a cavity therein.

Yet another example of the disclosure is directed to the chuck apparatus as described above where a suction force of the one or more second vacuum inlets exceeds a wicking force of couplant on the article.

Yet another example of the disclosure is directed to the chuck apparatus as described above further comprising one or more vacuum generators configured to control an operational state of one or more of the one or more second vacuum inlets.

Yet another example is directed to the chuck apparatus as described above further comprising one or more vacuum generators configured to control an operational state of one or more of the one or more first vacuum inlets.

Yet another example of the disclosure is directed to the chuck apparatus as described above where each of the first vacuum inlets operate independently from each of the second vacuum inlets.

Yet another example of the disclosure is directed to the chuck apparatus as described above where the first section has dimensions suitable to support a plurality of bonded wafer diameters.

Yet another example of the disclosure is directed to the chuck apparatus as described above where the one or more regions include portions that are distinct from the first vacuum inlets.

Yet another example of the disclosure is directed to the chuck apparatus as described above where the first vacuum inlets are configured to apply suction to a surface of the article to inhibit warpage of the article.

Yet another example of the disclosure is directed to another example of a chuck apparatus to secure an article comprising: a first section configured to support an article; a second section configured to create a circumferential ring around a circumference of the article; and one or more vacuum inlets disposed in the annular ring configured to provide suction along the circumference of the article.

Yet another example of the disclosure is directed to the chuck apparatus to secure an article as described above where the suction along the circumference of the article inhibits ingress of couplant into an edge portion of the article or underneath the article.

Yet another example of the disclosure is directed to the chuck apparatus to secure an article as described above where the second section comprises a structural ring member having a cavity therein.

Yet another example of the disclosure is directed to the chuck apparatus to secure an article as described above where a suction force of the one or more vacuum inlets exceeds a wicking force of couplant on the article.

Yet another example of the disclosure is directed to the chuck apparatus to secure an article as described above where a suction force of the one or more vacuum inlets inhibits ingress of couplant to an edge surface of the article.

Another example of the disclosure is directed to a method for utilizing a chuck, the method comprising: positioning an article on a first surface of a chuck; suctioning at least a first portion of the article on the first surface of the chuck, utilizing one or more first vacuum inlets; suctioning at least a second portion of the article on at least a portion of an annular ring of the chuck, utilizing one or more second vacuum inlets; depositing a couplant on at least a portion of an upper surface of the article; and suctioning at least a portion of the couplant from an edge portion of the article using the one or more second vacuum inlets.

The method for utilizing a chuck as described above where the first portion of the article is a planar surface and where the second portion of the article is an annular surface.

The method for utilizing a chuck as described above further comprising: operating the first vacuum inlets and second vacuum inlets independently.

The method for utilizing a chuck as described above further comprising providing a portion of the first surface of the chuck that provides a region that is distinct from the suction region.

The method for utilizing a chuck as described above where the article is a wafer.

The method for utilizing a chuck as described above where the second vacuum inlets provide suction forces that exceed wicking forces.

The above systems, devices, methods, processes, and the like may be realized in hardware, software, or any combination of these suitable for a particular application. The hardware may include a general-purpose computer and/or dedicated computing device. This includes realization in one or more microprocessors, microcontrollers, embedded microcontrollers, programmable digital signal processors or other programmable devices or processing circuitry, along with internal and/or external memory. This may also, or instead, include one or more application specific integrated circuits, programmable gate arrays, programmable array logic components, or any other device or devices that may be configured to process electronic signals. It will further be appreciated that a realization of the processes or devices described above may include computer-executable code created using a structured programming language such as C, an object oriented programming language such as C++, or any other high-level or low-level programming language (including assembly languages, hardware description languages, and database programming languages and technologies) that may be stored, compiled or interpreted to run on one of the above devices, as well as heterogeneous combinations of processors, processor architectures, or combinations of different hardware and software. In another implementation, the methods may be embodied in systems that perform the steps thereof, and may be distributed across devices in a number of ways. At the same time, processing may be distributed across devices such as the various systems described above, or all of the functionality may be integrated into a dedicated, standalone device or other hardware. In another implementation, means for performing the steps associated with the processes described above may include any of the hardware and/or software described above. All such permutations and combinations are intended to fall within the scope of the present disclosure.

While this disclosure is susceptible of embodiment in many different forms, there is shown in the drawings and described in detail specific examples, with the understanding that the present disclosure is to be considered as an example of the principles and not intended to be limited to the specific examples shown and described. In the description, like reference numerals may be used to describe the same, similar or corresponding parts in the several views of the drawings.

In this document, relational terms such as first and second, top and bottom, and the like may be used solely to distinguish one entity or action from another entity or action without necessarily requiring or implying any actual such relationship or order between such entities or actions. The terms "comprises," "comprising," "includes," "including," "has," "having," or any other variations thereof, are intended to cover a non-exclusive inclusion, such that a process, method, article, or apparatus that comprises a list of elements does not include only those elements but may include other elements not expressly listed or inherent to such process, method, article, or apparatus. An element preceded by "comprises ...a" does not, without more constraints, preclude the existence of additional identical elements in the process, method, article, or apparatus that comprises the element.

Reference throughout this document to "one embodiment," "certain embodiments," "an embodiment," "implementation(s)," "aspect(s)," or similar terms means that a particular feature, structure, or characteristic described in connection with the embodiment is included in at least one embodiment of the present invention. Thus, the appearances of such phrases or in various places throughout this specification are not necessarily all referring to the same embodiment. Furthermore, the particular features, structures, or characteristics may be combined in any suitable manner in one or more embodiments without limitation.

The term "or" as used herein is to be interpreted as an inclusive or meaning any one or any combination. Therefore, "A, B or C" means "any of the following: A; B; C; A and B; A and C; B and C; A, B and C." An exception to this definition will occur only when a combination of elements, functions, steps or acts are in some way inherently mutually exclusive. Also, grammatical conjunctions are intended to express any and all disjunctive and conjunctive combinations of conjoined clauses, sentences, words, and the like, unless otherwise stated or clear from the context. Thus, the term "or" should generally be understood to mean "and/or" and so forth.

References to items in the singular should be understood to include items in the plural, and vice versa, unless explicitly stated otherwise or clear from the text.

Recitation of ranges of values herein are not intended to be limiting, referring instead individually to any and all values falling within the range, unless otherwise indicated, and each separate value within such a range is incorporated into the specification as if it were individually recited herein. The words "about," "approximately," or the like, when accompanying a numerical value, are to be construed as indicating a deviation as would be appreciated by one of ordinary skill in the art to operate satisfactorily for an intended purpose. Ranges of values and/or numeric values are provided herein as examples only, and do not constitute a limitation on the scope of the described examples. The use of any and all examples, or exemplary language ("e.g.," "such as," or the like) provided herein, is intended merely to better illuminate the examples and does not pose a limitation on the scope of the examples. No language in the specification should be construed as indicating any unclaimed element as essential to the practice of the examples.

For simplicity and clarity of illustration, reference numerals may be repeated among the figures to indicate corresponding or analogous elements. Numerous details are set forth to provide an understanding of the examples described herein. The examples may be practiced without these details. In other instances, well-known methods, procedures, and components have not been described in detail to avoid obscuring the examples described. The description is not to be considered as limited to the scope of the examples described herein.

In the following description, it is understood that terms such as "first,""second," "top," "bottom," "up," "down," "above," "below," and the like, are words of convenience and are not to be construed as limiting terms.

The various representative examples, which have been described in detail herein, have been presented by way of example and not by way of limitation. It will be understood by those skilled in the art that various changes may be made in the form and details of the described examples resulting in equivalent embodiments that remain within the scope of the appended claims.

## Claims

1. A wafer chuck apparatus (300) operable to support wafers during acoustic inspection using a liquid couplant comprising:
a first section (350) configured to support at least a portion of a wafer (320);
one or more first vacuum inlets disposed in one or more regions of the first section and configured to be couplable to one or more first vacuum generators to apply suction to the at least a portion of the wafer (320);
a second section (380) configured to create an annular ring around a circumference of the wafer (320); and
one or more second vacuum inlets disposed in the annular ring and configured to be couplable to one or more second vacuum generators to apply suction along the circumference of the wafer (320);
the wafer chuck apparatus being **characterized in that**
the first section (350) is configured to be inserted into the second section (380), whereby a cavity is formed in which a vacuum can remove the liquid couplant from the circumference of the wafer (320), and
wherein the one or more second vacuum inlets are configured to apply suction to said cavity.

2. The apparatus of claim 1, wherein the first section comprises two or more regions, each region of the first section having one or more associated ones of the one or more first vacuum inlets; and/or
wherein the first section has dimensions suitable to accommodate a plurality of bonded wafers of varying diameters.

3. The apparatus of claim 1 or 2, wherein the second section comprises a structural ring member having the cavity therein.

4. The apparatus of any of claims 1 to 3, wherein a suction force of the one or more second vacuum inlets when coupled to the one or more second vacuum generators exceeds a wicking force of absorption of the liquid couplant by the wafer.

5. The apparatus of any of claims 1 to 4, further comprising one or more of the one or more first vacuum generators and the one or more second vacuum generators configured to control an operational state of one or more of the one or more first vacuum inlets and the one or more second vacuum inlets.

6. The apparatus of any of claims 1 to 5, wherein each of the first vacuum inlets coupled to the one or more first vacuum generators operate independently from each of the second vacuum inlets coupled to the one or more second vacuum generators.

7. The apparatus of any of claims 1 to 6, wherein the one or more regions include portions that are distinct from the first vacuum inlets; and/or
wherein the first vacuum inlets are configured to apply suction to a surface of the wafer to inhibit warpage of the wafer.

8. The apparatus of claim 1, wherein the suction along the circumference of the wafer generated by the one or more second vacuum generators inhibits ingress of the liquid couplant into an edge portion of the wafer or underneath the wafer.

9. A method of using the wafer chuck for supporting wafers during acoustic inspection using a liquid couplant according to any of claims 1 to 8, comprising:
positioning a wafer on a first surface of the wafer chuck;
suctioning at least a first portion of the wafer on the first surface of the wafer chuck, utilizing the one or more first vacuum generators coupled to the one or more first vacuum inlets of the wafer chuck;
suctioning at least a second portion of the wafer on at least a portion of an annular ring of the wafer chuck, utilizing the one or more second vacuum generators coupled to the one or more second vacuum inlets of the wafer chuck;
depositing a liquid couplant on at least a portion of an upper surface of the wafer; and
suctioning at least a portion of the liquid couplant from an edge portion of the wafer using the one or more second vacuum inlets.

10. The method of claim 9, wherein the first portion of the wafer is a planar surface and wherein the second portion of the wafer is an annular portion.

11. The method of claim 9 or 10, further comprising:
operating the one or more first vacuum inlets coupled to one or more first vacuum generators and one or more second vacuum inlets coupled to one or more second vacuum generators independently.

12. The method of any of claims 9 to 11, further comprising:
providing a portion of the first surface of the wafer chuck that provides a region that is distinct from a suction region.

## Patentansprüche

1. Halbleiterscheiben-Einspannvorrichtung (300), die betreibbar ist, um Halbleiterscheiben während der akustischen Inspektion unter Verwendung eines flüssigen Kopplungsmittels zu stützen, umfassend:
einen ersten Bereich (350), der dazu konfiguriert ist, mindestens einen Abschnitt einer Halbleiterscheibe (320) zu stützen;
einen oder mehrere erste Vakuumeingänge, die in einer oder mehreren Regionen des ersten Bereichs angeordnet sind und dazu konfiguriert sind, an einen oder mehrere erste Vakuumgeneratoren koppelbar zu sein, um eine Saugwirkung auf den mindestens einen Abschnitt der Halbleiterscheibe (320) aufzubringen;
einen zweiten Bereich (380), der dazu konfiguriert ist, einen annularen Ring um einen Umfang der Halbleiterscheibe (320) zu erzeugen; und
einen oder mehrere zweite Vakuumeingänge, die in dem annularen Ring angeordnet sind und dazu konfiguriert sind, an einen oder mehrere zweite Vakuumgeneratoren koppelbar zu sein, um eine Saugwirkung entlang des Umfangs der Halbleiterscheibe (320) aufzubringen;
wobei die Halbleiterscheiben-Einspannvorrichtung **dadurch gekennzeichnet ist, dass**
der erste Bereich (350) dazu konfiguriert ist, in den zweiten Bereich (380) eingesetzt zu werden, wodurch ein Hohlraum ausgebildet wird, in dem ein Vakuum das flüssige Kopplungsmittel von dem Umfang der Halbleiterscheibe (320) entfernen kann, und
wobei der eine oder die mehreren zweiten Vakuumeingänge dazu konfiguriert sind, eine Saugwirkung auf den Hohlraum aufzubringen.

2. Vorrichtung nach Anspruch 1, wobei der erste Bereich zwei oder mehr Regionen umfasst, wobei jeder Region des ersten Bereichs ein oder mehrere von dem einen oder den mehreren ersten Vakuumeingängen zugeordnet sind; und/oder
wobei der erste Bereich Abmessungen aufweist, die geeignet sind, um eine Vielzahl von gebondeten Halbleiterscheiben mit unterschiedlichen Durchmessern aufzunehmen.

3. Vorrichtung nach Anspruch 1 oder 2, wobei der zweite Bereich ein strukturelles Ringelement mit einem Matrizenhohlraum darin umfasst.

4. Vorrichtung nach einem der Ansprüche 1 bis 3, wobei eine Saugkraft des einen oder der mehreren zweiten Vakuumeingänge, wenn sie an den einen oder die mehreren zweiten Vakuumgeneratoren gekoppelt sind, eine Absorptionsdochtkraft des flüssigen Kopplungsmittels durch die Halbleiterscheibe übersteigt.

5. Vorrichtung nach einem der Ansprüche 1 bis 4, ferner umfassend einen oder mehrere von dem einen oder den mehreren ersten Vakuumgeneratoren und dem einen oder den mehreren zweiten Vakuumgeneratoren, die dazu konfiguriert sind, einen Betriebszustand eines oder mehrerer von dem einen oder den mehreren ersten Vakuumeingängen und dem einen oder den mehreren zweiten Vakuumeingängen zu steuern.

6. Vorrichtung nach einem der Ansprüche 1 bis 5, wobei jeder von den ersten Vakuumeingängen, die an den einen oder die mehreren ersten Vakuumgeneratoren gekoppelt sind, unabhängig von jedem von den zweiten Vakuumeingängen, die an den einen oder die mehreren zweiten Vakuumgeneratoren gekoppelt sind, betrieben wird.

7. Vorrichtung nach einem der Ansprüche 1 bis 6, wobei die eine oder die mehreren Regionen Abschnitte enthalten, die sich von den ersten Vakuumeingängen unterscheiden; und/oder
wobei die ersten Vakuumeingänge dazu konfiguriert sind, eine Saugwirkung auf eine Oberfläche der Halbleiterscheibe aufzubringen, um ein Verziehen der Halbleiterscheibe zu verhindern.

8. Vorrichtung nach Anspruch 1, wobei die durch den einen oder die mehreren zweiten Vakuumgeneratoren erzeugte Saugwirkung entlang des Umfangs der Halbleiterscheibe ein Eindringen des flüssigen Kopplungsmittels in einen Randabschnitt der Halbleiterscheibe oder unterhalb der Halbleiterscheibe verhindert.

9. Verfahren zum Verwenden der Halbleiterscheiben-Einspannung zum Stützen von Halbleiterscheiben während der akustischen Inspektion unter Verwendung eines flüssigen Kopplungsmittels nach einem der Ansprüche 1 bis 8, umfassend:
Positionieren einer Halbleiterscheibe auf einer ersten Oberfläche der Halbleiterscheiben-Einspannung;
Saugen mindestens eines ersten Abschnitts der Halbleiterscheibe an der ersten Oberfläche der Halbleiterscheiben-Einspannung unter Verwendung des einen oder der mehreren ersten Vakuumgeneratoren, die an den einen oder die mehreren ersten Vakuumeingänge der Halbleiterscheiben-Einspannung gekoppelt sind;
Saugen mindestens eines zweiten Abschnitts der Halbleiterscheibe an mindestens einem Abschnitt eines annularen Rings der Halbleiterscheiben-Einspannung unter Verwendung des einen oder der mehreren zweiten Vakuumgeneratoren, die an den einen oder die mehreren zweiten Vakuumeingänge der Halbleiterscheiben-Einspannung gekoppelt sind;
Abscheiden eines flüssigen Kopplungsmittels auf mindestens einem Abschnitt einer oberen Oberfläche der Halbleiterscheibe; und
Saugen mindestens eines Abschnitts des flüssigen Kopplungsmittels von einem Randabschnitt der Halbleiterscheibe unter Verwendung des einen oder der mehreren zweiten Vakuumeingänge.

10. Verfahren nach Anspruch 9, wobei der erste Abschnitt der Halbleiterscheibe eine ebene Oberfläche ist und wobei der zweite Abschnitt der Halbleiterscheibe ein annularer Abschnitt ist.

11. Verfahren nach Anspruch 9 oder 10, ferner umfassend:
Betreiben des einen oder der mehreren ersten Vakuumeingänge, die an einen oder mehrere erste Vakuumgeneratoren gekoppelt sind, und eines oder mehrerer zweiter Vakuumeingänge, die an einen oder mehrere zweite Vakuumgeneratoren gekoppelt sind, unabhängig voneinander.

12. Verfahren nach einem der Ansprüche 9 bis 11, ferner umfassend: Bereitstellen eines Abschnitts der ersten Oberfläche der Halbleiterscheiben-Einspannung, der eine Region bereitstellt, die sich von einer Saugregion unterscheidet.

## Revendications

1. Appareil de support de plaquette semi-conductrice (300) utilisable pour supporter des plaquettes semi-conductrices lors d'une inspection acoustique à l'aide d'un milieu de couplage liquide, comprenant :
une première section (350) configurée pour supporter au moins une partie d'une plaquette semi-conductrice (320) ;
une ou plusieurs premières entrées de vide disposées dans une ou plusieurs régions de la première section et configurées pour pouvoir être couplées à un ou plusieurs premiers générateurs de vide pour appliquer une aspiration sur l'au moins une partie de la plaquette semi-conductrice (320) ;
une seconde section (380) configurée pour créer une bague annulaire autour d'une circonférence de la plaquette semi-conductrice (320) ; et
une ou plusieurs secondes entrées de vide disposées dans la bague annulaire et configurées pour pouvoir être couplées à un ou plusieurs seconds générateurs de vide pour appliquer une aspiration le long de la circonférence de la plaquette semi-conductrice (320) ;
l'appareil de support de plaquette semi-conductrice étant **caractérisé en ce que** la première section (350) est configurée pour être insérée dans la seconde section (380), moyennant quoi une cavité est formée dans laquelle un vide peut éliminer le milieu de couplage liquide de la circonférence de la plaquette semi-conductrice (320), et
dans lequel l'une ou plusieurs secondes entrées de vide sont configurées pour appliquer une aspiration à ladite cavité.

2. Appareil selon la revendication 1, dans lequel la première section comprend deux régions ou plus, chaque région de la première section ayant une ou plusieurs entrées de vide associées parmi l'une ou plusieurs premières entrées de vide ; et/ou
dans lequel la première section a des dimensions appropriées pour recevoir une pluralité de plaquettes semi-conductrices collées de diamètres variables.

3. Appareil selon la revendication 1 ou 2, dans lequel la seconde section comprend un élément de bague structurel ayant la cavité à l'intérieur de celui-ci.

4. Appareil selon l'une quelconque des revendications 1 à 3, dans lequel une force d'aspiration de l'une ou plusieurs secondes entrées de vide lorsqu'elles sont couplées à l'un ou plusieurs seconds générateurs de vide dépasse une force d'absorption par mèche du milieu de couplage liquide par la plaquette semi-conductrice.

5. Appareil selon l'une quelconque des revendications 1 à 4, comprenant en outre un ou plusieurs parmi l'un ou plusieurs premiers générateurs de vide et l'un ou plusieurs seconds générateurs de vide configurés pour commander un état opérationnel d'une ou plusieurs parmi l'une ou plusieurs premières entrées de vide et l'une ou plusieurs secondes entrées de vide.

6. Appareil selon l'une quelconque des revendications 1 à 5, dans lequel chacune des premières entrées de vide couplées à l'un ou plusieurs premiers générateurs de vide fonctionne indépendamment de chacune des secondes entrées de vide couplées à l'un ou plusieurs seconds générateurs de vide.

7. Appareil selon l'une quelconque des revendications 1 à 6, dans lequel l'une ou plusieurs régions comprennent des parties qui sont distinctes des premières entrées de vide ; et/ou
dans lequel les premières entrées de vide sont configurées pour appliquer une aspiration à une surface de la plaquette semi-conductrice pour inhiber la déformation de la plaquette semi-conductrice.

8. Appareil selon la revendication 1, dans lequel l'aspiration le long de la circonférence de la plaquette semi-conductrice générée par l'un ou plusieurs seconds générateurs de vide empêche l'entrée du milieu de couplage liquide dans une partie de bord de la plaquette semi-conductrice ou sous la plaquette semi-conductrice.

9. Procédé d'utilisation du support de plaquette semi-conductrice pour supporter des plaquettes semi-conductrices lors d'une inspection acoustique à l'aide d'un milieu de couplage liquide selon l'une quelconque des revendications 1 à 8, comprenant :
le positionnement d'une plaquette semi-conductrice sur une première surface du support de plaquette semi-conductrice ;
l'aspiration d'au moins une première partie de la plaquette semi-conductrice sur la première surface du support de plaquette semi-conductrice, en utilisant l'un ou plusieurs premiers générateurs de vide couplés à l'une ou plusieurs premières entrées de vide du support de plaquette semi-conductrice ;
l'aspiration d'au moins une seconde partie de la plaquette semi-conductrice sur au moins une partie d'une bague annulaire du support de plaquette semi-conductrice, en utilisant l'un ou plusieurs seconds générateurs de vide couplés à l'une ou plusieurs secondes entrées de vide du support de plaquette semi-conductrice ;
le dépôt d'un agent de couplage liquide sur au moins une partie d'une surface supérieure de la plaquette semi-conductrice ; et
l'aspiration d'au moins une partie du milieu de couplage liquide à partir d'une partie de bord de la plaquette semi-conductrice à l'aide de l'une ou plusieurs secondes entrées de vide.

10. Procédé selon la revendication 9, dans lequel la première partie de la plaquette semi-conductrice est une surface plane et dans lequel la seconde partie de la plaquette semi-conductrice est une partie annulaire.

11. Procédé selon la revendication 9 ou 10, comprenant en outre :
le fonctionnement de l'une ou plusieurs premières entrées de vide couplées à un ou plusieurs premiers générateurs de vide et de l'une ou plusieurs secondes entrées de vide couplées à un ou plusieurs seconds générateurs de vide indépendamment.

12. Procédé selon l'une quelconque des revendications 9 à 11, comprenant en outre :
la fourniture d'une partie de la première surface du support de plaquette semi-conductrice qui fournit une région qui est distincte d'une région d'aspiration.
